# EUROPEAN PATENT SPECIFICATION

(11) **EP 4 333 048 B1**
(45) Date of publication and mention of the grant of the patent: **24.09.2025**
(21) Application number: 22306277.9
(22) Date of filing: 29.08.2022
(51) Int. Cl.: H01L 23/473, F28F 3/02, F28F 3/04, F28F 3/12, H05K 7/20

(54) **COOLING BLOCK FOR COOLING A HEAT-GENERATING ELECTRONIC COMPONENT AND METHOD FOR MANUFACTURING THEREOF**
KÜHLBLOCK ZUR KÜHLUNG EINES WÄRMEERZEUGENDEN ELEKTRONISCHEN BAUTEILS UND HERSTELLUNGSVERFAHREN DAFÜR
BLOC DE REFROIDISSEMENT POUR REFROIDIR UN COMPOSANT ÉLECTRONIQUE GÉNÉRANT DE LA CHALEUR ET SON PROCÉDÉ DE FABRICATION

(43) Date of publication of application: 06.03.2024
(73) Proprietor: OVH, 59100 Roubaix (FR)
(72) Inventor: BAUDUIN, Hadrien, 59650 Villeneuve d'Ascq (FR); CHEHADE, Ali, 59283 Moncheaux (FR)
(74) Representative: BCF Global

(56) References cited:
- CN-B- 104 465 562
- DE-A1- 102011 118 483
- US-A- 5 544 703
- US-A1- 2003 071 525
- US-A1- 2014 138 063

## Description

### FIELD OF TECHNOLOGY

The present technology relates to cooling blocks and methods for manufacturing thereof.

### BACKGROUND

Heat dissipation is an important consideration for computer systems. Notably, many components of a computer system, such as a processor (also referred to as central processing unit (CPU)), generate heat and thus require cooling to avoid performance degradation and, in some cases, failure. Similar considerations arise for systems other than computer systems (e.g., power management systems). Thus, in many cases, different types of cooling solutions are implemented to promote heat dissipation from heat-generating electronic components, with the objective being to collect and conduct thermal energy away from these heat-generating electronic components. For instance, in a data center, in which multiple electronic systems (e.g., servers, networking equipment, power equipment) are continuously operating and generating heat, such cooling solutions may be particularly important.

One example of a cooling solution is a heat sink which relies on a heat transfer medium (e.g., a gas or liquid) to carry away the heat generated by a heat-generating electronic component. For instance, a cooling block (sometimes referred to as a "water block" or "cold plate") can be thermally coupled to a heat-generating electronic component and water (or other fluid) is made to flow through a conduit in the cooling block to absorb heat from the heat-generating electronic component. As water flows out of the cooling block, so does the thermal energy collected thereby. However, in many cases, efficient cooling blocks may be difficult and/or expensive to manufacture.

There is therefore a desire for a cooling block which can alleviate at least some of these drawbacks.

CN 104 465 562 B describes a chain type staggered micro-channel structure. The chain type staggered micro-channel structure comprises a substrate and microfluid passageways arranged on the substrate. Each microfluid passageway comprises twin-branch micro fluid passageway bodies which intersect and are separated in a periodic mode. Intersections are formed in the positions where the branch micro fluid passageway bodies intersect, and bifurcation openings are formed in the positions where the branch micro fluid passageway bodies are separated. Micro passageways are arc-shaped channels periodically changing and are formed by smoothly connecting different gradients of arcs. Every two adjacent channels are symmetrical, intersect every other distance and are arranged according to arcs after intersecting. A cooling working medium smoothly flows in the channels.

US 2014/0138063 A1 describes a cooling fin structure used in a cooler for an electric device. The cooling fin includes a plurality of pin fins arranged in a zigzag form in a coolant passage. Each of the pin fins has a circular portion having a circular cross-section, and irregularly shaped portions provided contiguously on the upstream and downstream sides of the circular portion as viewed in a direction of flow of the coolant.

### SUMMARY

It is an object of the present technology to ameliorate at least some of the inconveniences present in the prior art.

The object of the invention is solved by a cooling block according to claim 1 and by a method according to claim 13. Preferred embodiments are presented in the dependent claims.

### Continued on page 2a

Embodiments of the present technology each have at least one of the above-mentioned object and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of embodiments of the present technology will become apparent from the following description, the accompanying drawings and the appended claims.

It is to be understood that terms relating to the position and/or orientation of components such as "upper", "lower", "top", "bottom", "front", "rear", "left", "right", "longitudinal", "lateral", "vertical", etc. are used herein to simplify the description and are not intended to be limitative of the particular position/orientation of the components in use.

### BRIEF DESCRIPTION OF THE DRAWINGS

For a better understanding of the present technology, as well as other aspects and further features thereof, reference is made to the following description which is to be used in conjunction with the accompanying drawings, where:
Fig. 1 is a perspective view, taken from a top, front, left side, of a cooling block according to an embodiment of the present technology;
Fig. 2 is a cross-sectional view of the cooling block of Fig. 1 taken along line 2-2 in Fig. 1, and showing a heat-generating electronic component cooled thereby;
Fig. 3 is a top plan view of a base of the cooling block of Fig. 1;
Fig. 4 is a detailed view of part of Fig. 3 showing multiple passages of an internal fluid conduit of the cooling block;
Fig. 5 is a top plan view of the base of the cooling block of Fig. 1 after having formed a first channel of a first one of the passages of the cooling block;
Fig. 6 is a top plan view of the base of the cooling block of Fig. 1 after having formed a second channel of the first one of the passages of the cooling block;
Fig. 7 is a top plan view of the base of the cooling block of Fig. 1 after having formed a second one of the passages of the cooling block;
Fig. 8 is a top plan view of the base of the cooling block according to an alternative embodiment;
Fig. 9 is a top plan view of the base of the cooling block according to another alternative embodiment;
Fig. 10 is a top plan view of part of the base of the cooling block according to an alternative embodiment;
Fig. 11 is a top plan view of part of the base of the cooling block according to another alternative embodiment;
Fig. 12 is a top plan view of the base of the cooling block according to an alternative embodiment in which each passage is defined by two pin rows;
Fig. 13 is a detailed view of section A in Fig. 12;
Figs. 14 to 16 are top plan views of the base of Fig. 12 in progressive stages of manufacturing thereof;
Fig. 17 is a top plan view of part of the base of the cooling block according to an alternative embodiment in which the passages of the cooling block have a different width;
Fig. 18 is a top plan view of part of the base of the cooling block according to an alternative embodiment in which each passage of the cooling block is defined in part by three pin rows;
Fig. 19 is a top plan view of the base of the cooling block according to an alternative embodiment in which the cooling block has a single passage defined in part by twenty-one pin rows;
Fig. 20 is a top plan view of part of the base of the cooling block according to an alternative embodiment in which the pins of the cooling block have a lacrimiform shape;
Fig. 21 is a top plan view of part of the base of the cooling block according to another alternative embodiment in which the pins of the cooling block have a lacrimiform shape; and
Fig. 22 is a top plan view of part of the base of the cooling block according to another alternative embodiment in which the pins of the cooling block have an asymmetric lacrimiform shape.

### DETAILED DESCRIPTION

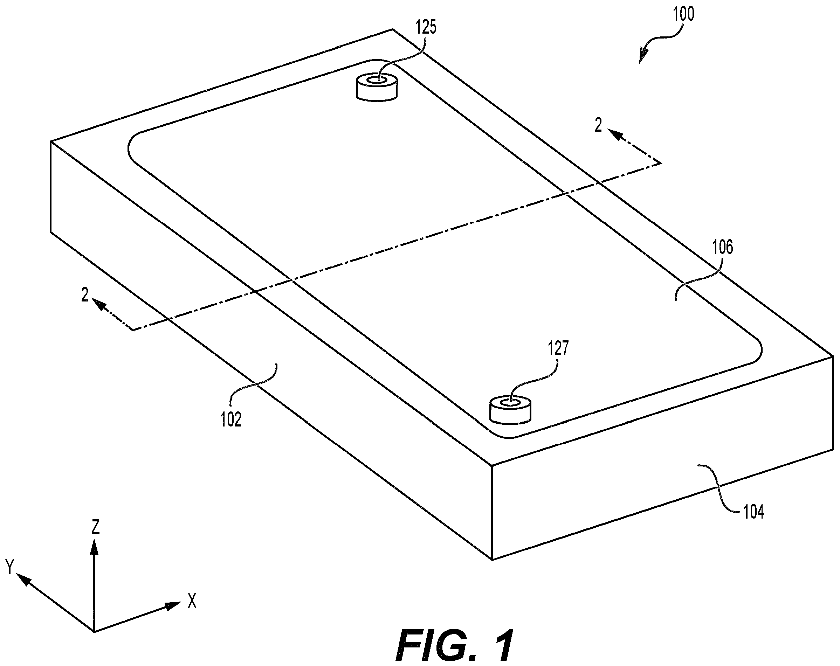

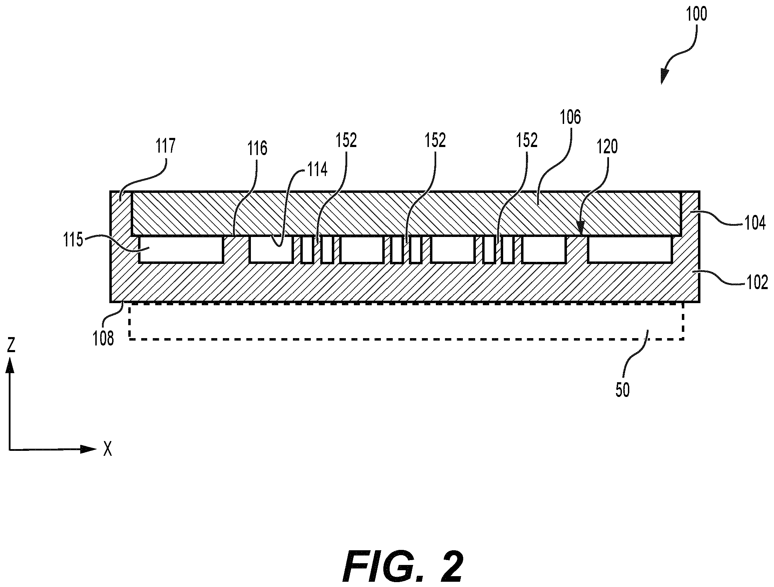

Figs. 1 and 2 illustrate a cooling block 100 in accordance with an embodiment of the present technology. The cooling block 100 is configured for cooling a heat-generating electronic component 50 (illustrated schematically in Fig. 2). In this example, the heat-generating electronic component 50 is a central processing unit (CPU). For instance, the heat-generating electronic component 50 may be part of a server operating within a data center. In use, the heat-generating electronic component 50 generates a significant amount of heat and can therefore benefit from cooling. It is contemplated that the heat-generating electronic component 50 could be any other suitable heat-generating electronic component (e.g., a graphics processing unit (GPU), a semiconductor, a memory unit, etc.).

As will be described in detail below, the cooling block 100 is configured, via the design of a fluid conduit 115 thereof, to promote turbulent flow of cooling fluid within the fluid conduit 115. Increased turbulent flow within the fluid conduit 115 can optimize the heat absorption capability of the cooling block 100, therefore resulting in the cooling block 100 more efficiently absorbing heat from the heat-generating electronic component 50.

The cooling block 100 will now be described with reference to Figs. 1 to 3. The cooling block 100 has a body 102 including a base 104 and a cover 106 which are connected to each other. For instance, in this example, the cover 106 is welded to the base 104 (e.g., via laser welding). The cover 106 may be fixed to the base 104 differently in other embodiments. As shown in Fig. 2, the base 104 includes a thermal transfer surface 108 disposed on a lower side of the base 104. The thermal transfer surface 108 is configured to be placed in thermal contact with the heat-generating electronic component 50. It is to be understood that the thermal transfer surface 108 can be in thermal contact with the heat-generating electronic component 50 whether the thermal transfer surface is in direct contact with the heat-generating electronic component 50 or a thermal interface material (e.g., a thermal paste, a thermal pad, a graphite sheet, etc.) is disposed therebetween with the express intention of improving the heat transfer between the heat-generating electronic component 50 and the cooling block 100.

As shown in Fig. 2, together, the base 104 and the cover 106 define the internal fluid conduit 115 within which a cooling fluid is circulated to absorb heat from the heat-generating electronic component 50. The internal fluid conduit 115 extends from an inlet 110 to an outlet 112. In this example, the inlet 110 and the outlet 112 are disposed near opposite corners of the cooling block 100. The inlet 110 and the outlet 112 could be disposed at different locations in other embodiments. Furthermore, in this embodiment, the cooling fluid circulated through the internal fluid conduit 115 is demineralized water. However, the cooling fluid may be any other suitable cooling fluid (e.g., a refrigerant) in other embodiments. In some embodiments, the cooling fluid may be capable of two-phase flow such that the cooling fluid can change phases from liquid to gas and vice-versa based on a temperature thereof. The cooling fluid circulating within the cooling block 100 will thus, at some point, be in the liquid phase, however the cooling fluid may not necessarily be in liquid phase throughout (e.g., the cooling fluid may evaporate from liquid to gas when its temperature reaches a certain value).

In this embodiment, the cover 106 is received in a pocket 120 (Fig. 2) defined by the base 104 such that a lower surface 114 of the cover 104 is in contact with an upper surface 116 of the base 104. The upper surface 116 and a rim portion 117 of the base 104 define the pocket 120 of the base 104 in which the cover 106 is received. The upper surface 116 is disposed on an upper side of the base 104 (i.e., on an opposite side from the thermal transfer surface 108) and therefore is offset from the thermal transfer surface 108 in a height direction (i.e., along the Z-axis) of the cooling block 100 that is normal to the thermal transfer surface 108. In other embodiments, the base 104 may not define a pocket 120 to receive the cover 106 (e.g., the cover 106 may be welded to the base 104 along a periphery thereof). In such embodiments, the upper surface 116 of the base 104 is not surrounded by the rim portion 117.

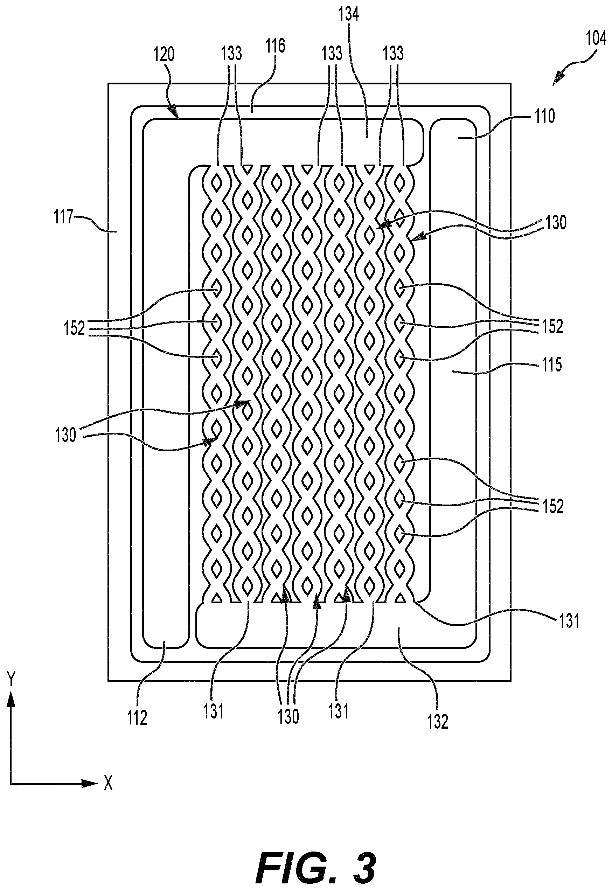

With reference to Figs. 2 and 3, in this embodiment, a path of the fluid conduit 115 is defined by the base 104 which is manufactured to have a plurality of passages 130 that are designed such as to promote turbulent flow as the cooling fluid flows within the passages 130. The manner in which the base 104 is designed and manufactured will be described in greater detail further below.

In this embodiment, the cover 106 is a plate member that is generally planar and shaped to be received within the pocket 120. Notably, the lower surface 114 of the cover 106 is a flat surface that closes off the fluid conduit 115 from its upper side. It is contemplated that, in other embodiments, the cover 106 could define the path of the fluid conduit 115 in part or in its entirety (e.g., the passages 130 could instead be defined by the cover 106). As shown in Fig. 1, in this embodiment, an inlet connection 125 and an outlet connection 127 (e.g., pipes) are provided on the cover 106 and are in fluid communication with the inlet 110 and the outlet 112 of the fluid conduit 115 respectively. The inlet and outlet connections 125, 127 are connected to additional piping (not shown) to route cooling fluid to the cooling block 100 and discharge cooling fluid from the cooling block 100 respectively.

The fluid conduit 115 will now be described in greater detail with reference to Fig. 3. In this embodiment, the fluid conduit 115 has an inlet manifold portion 132 that extends from the inlet 110 and an outlet manifold portion 134 that extends from the outlet 112. The passages 130 extend between the inlet and outlet manifold portions 132, 134 thereby fluidly connecting the inlet manifold portion 132 to the outlet manifold portion 134. As can be seen, in this embodiment, the passages 130 are parallel to each other and extend in a longitudinal direction (i.e., along the Y-axis) of the cooling block 100. In addition, the passages 130 are in a parallel flow configuration whereby cooling fluid flows through the multiple passages 130 in parallel rather than in series. In other words, as cooling fluid flows from the inlet 110 to the outlet 112 of the fluid conduit 115, the cooling fluid flow is split between the passages 130.

It is contemplated that, in other embodiments, the inlet and outlet manifolds 132, 134 may be omitted. For instance, as will be seen further below, in some embodiments, multiple passages 130 may be fluidly connected to each other in series rather than in parallel.

The particular configuration of each passage 130 will now be described. In this embodiment, all of the passages 130 have generally the same configuration and therefore only one of the passages 130 will be described in detail herein. It is to be understood that the same description applies to the other passages 130 unless mentioned otherwise. As can be seen in Fig. 3, the passage 130 extends between an inlet point 131 and an outlet point 133 along the longitudinal direction of the cooling block 100. The outlet point 133 is downstream from the inlet point 131. In this embodiment, the inlet and outlet points 131, 133 are located at the inlet and outlet manifold portions 132, 134 respectively. The passage 130 is defined between opposite internal sidewalls 140, 142 extending between the inlet and outlet points 131, 133 and facing each other such that, as cooling fluid flows within the passage 130, the cooling fluid is bound between the internal sidewalls 140, 142.

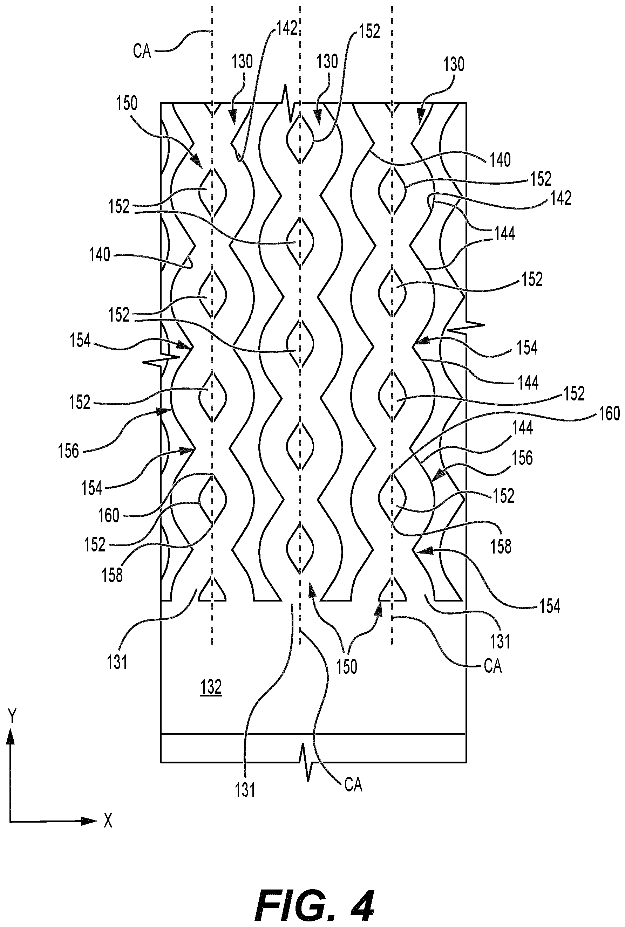

With particular reference to Fig. 4, in this embodiment, each of the internal sidewalls 140, 142 has a scalloped shape and thus comprises a plurality of rounded sections 144 distributed along the longitudinal direction of the cooling block 100. In this example, the rounded sections 144 are uniformly dimensioned, shaped and distributed. Each rounded section 144 has a concave side thereof facing inwardly toward a central linear axis CA that extends along the longitudinal direction of the cooling block 100. In this embodiment, the central linear axis CA bisects a width of the passage 130 measured along a lateral direction (i.e., along the X-axis) of the cooling block 100, which is normal to the longitudinal direction. The lateral direction may thus also be referred to as a "passage width direction". In this embodiment, the rounded sections 144 of the internal sidewall 140 are aligned with the rounded sections 144 of the internal sidewall 142 along the longitudinal direction such that respective middle points of the rounded sections 144 (i.e., points marking the middle of the lengths of the rounded sections 144 measured in the longitudinal direction) of the internal sidewalls 140, 142 are aligned with each other.

In this embodiment, the passage 130 is also defined in part by a pin row 150 including a multitude of pins 152 of the base 104. In use, the pins 152 deflect the cooling fluid flowing within the fluid conduit 115 toward either side of the central linear axis CA. As can be seen, the pin row 150 is disposed between the opposite internal sidewalls 140, 142. The pins 152 of the pin row 150 are spaced apart along the longitudinal direction and aligned with each other in the lateral direction such that the central linear axis CA traverses each pin 152. As can be seen, this arrangement of the pin row 150 imparts the passage 130 with a catenulate (i.e., chain-like) shape. More specifically, in this embodiment, the passage 130 has a plurality of constricted portions 154 and a plurality of expanded portions 156 disposed alternatingly along the longitudinal direction and which impart, together with the pins 152, the catenulate shape to the passage 130. The expanded portions 156 of the passage 130 are formed by the rounded sections 144 of the internal sidewalls 140, 142. The constricted and expanded portions 154, 156 are referenced as such due to their relative dimensions. Notably, the expanded portions 156 of the passage 130 have a width that is greater than a width of the constricted portions 154. The widths of the constricted and expanded portions 154, 156 are measured along the lateral direction. In this embodiment, the pins 152 are disposed along the expanded portions 156 (i.e., the pins 152 of the pin row 150 are contained within respective ones of the expanded portions 156).

Returning to Fig. 4, in this embodiment, each pin 152 of the pin row 150 defining the passage 130 has a lanceolate profile along a plane parallel to the thermal transfer surface 108 and traversing the pins 152. More specifically, each pin 152 is shaped like an ellipse albeit with first and second pointed ends 158, 160 opposite each other. As can be seen, in this embodiment, the first and second pointed ends 158, 160 are aligned in the lateral direction and the central linear axis CA of the passage 130 extends through both the first and second pointed ends 158, 160. In fact, in this example, the pins 152 are symmetric about the central linear axis CA. As will be described in other examples below, the pins 152 may be shaped differently in other embodiments.

Returning to Fig. 3, in this embodiment, the fluid conduit 115 has seven passages 130 extending parallel to each other, each passage 130 being defined in part by a corresponding pin row 150. It is contemplated that more or fewer passages 130 could be provided in other embodiments. Furthermore, in this embodiment, the constricted and expanded portions 154, 156 of consecutive ones of the passages 130 are offset from each other in the longitudinal direction. That is, the constricted portions 154 of a first passage 130 are offset, in the longitudinal direction, from the constricted portions 154 of a second passage 130 that is consecutive to the first passage 130. Rather, the constricted portions 154 of the first passage 130 are aligned, in the longitudinal direction, with the expanded portions 156 of the second passage 130. As such, the pins 152 of consecutive ones of the pin rows 150 (defining consecutive ones of the passages 130 respectively) are offset from each other along the longitudinal direction. Notably, a centerpoint of each pin 152 of a first pin row 150 (located at midlength between the opposite ends 158, 160 of the pin 152) is offset from the centerpoint of each pin 152 of a second pin row 150 that is consecutive to the first pin row 150. This may be helpful to more closely pack together the passages 130 which can increase the amount of pins 152 defining the fluid conduit 115 and also optimize a thickness of the material between consecutive passages 130, thereby optimizing the cooling provided by the cooling block 100.

This configuration of the passages 130 promotes turbulent flow and limits flow separation and recirculation of the cooling fluid as it flows through the fluid conduit 115, contrary to many conventional fluid conduit designs. In turn, this increases the heat absorbing capability of the cooling fluid which can therefore dissipate heat more efficiently from the heat-generating electronic component 50,

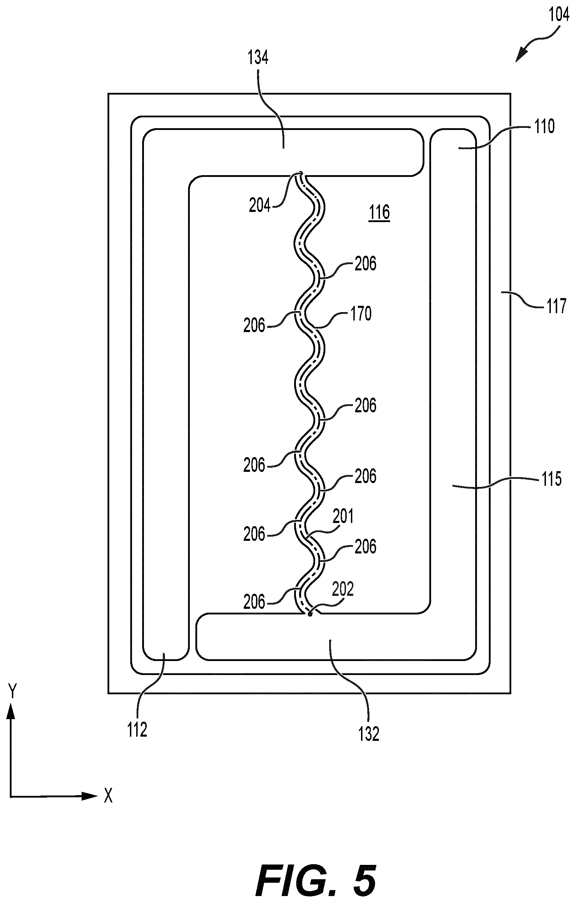

The manner in which the base 104 is manufactured will now be described with reference to Figs. 5 to 8 which illustrate the progressive forming of the passages 130. The fluid conduit 115 is machined, namely milled, onto a piece of material to form the finished base 104. In this example, the inlet and outlet manifold portions 132, 134 are already formed prior to machining the passages 130. It is contemplated that the inlet and outlet manifold portions 132, 134 may not yet be formed prior to machining the passages 130. In other embodiments, the inlet and outlet manifold portions 132, 134 may even be entirely omitted. As shown in Fig. 5, in order to form the passage 130, a first channel 170 is milled on the upper surface 116 of the base 104 following a path defined by a sinusoidal spline 201. The sinusoidal spline 201 extends in a longitudinal direction of the cooling block 100 from a first end 202 to a second end 204. In this embodiment, the first end 202 is located at an edge of the inlet manifold portion 132 and the second end 204 is located at an edge of the outlet manifold portion 134 such that the resulting first channel 170 interconnects the inlet and outlet manifold portions 132, 134. The sinusoidal spline 201 has the shape of a sinusoidal function, therefore oscillating periodically at a given amplitude and defining a plurality of peaks 206 at each half period thereof.

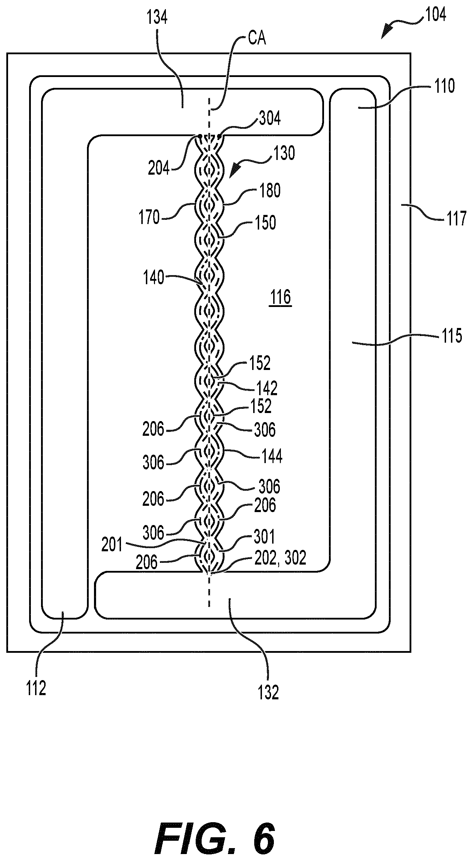

Next, as shown in Fig. 6, a second channel 180 is milled on the upper surface 116 of the base 104 following a path defined by another sinusoidal spline 301. The milling of the channels 170, 180 forms a corresponding pin row 150 as described above. The sinusoidal spline 301 extends in the longitudinal direction of the cooling block 100 from a first end 302 to a second end 304. In this embodiment, the first end 302 is located at an edge of the inlet manifold portion 132 and the second end 304 is located at an edge of the outlet manifold portion 134 such that the resulting second channel 180 interconnects the inlet and outlet manifold portions 132, 134. The sinusoidal spline 301 has the shape of a sinusoidal function, therefore oscillating periodically at a given amplitude (namely the same amplitude as the sinusoidal spline 201) and defining a plurality of peaks 306 at each half period thereof. As will be appreciated, in this embodiment, the sinusoidal spline 301 is completely out of phase with the sinusoidal spline 201 (i.e., 180° out of phase along the longitudinal direction). Notably, the peaks 306 of the sinusoidal spline 301 are aligned, in the longitudinal direction, with the peaks 206 of the sinusoidal spline 201 while being on opposite sides of the linear axis about which the sinusoidal splines 201, 301 are centered and oscillate.

In this embodiment, the first end 302 of the sinusoidal spline 301 is coincident with the first end 202 of the sinusoidal spline 201. The first ends 202, 302 of the channels 170, 180 may not be coincident in other embodiments.

As can be seen, the sinusoidal splines 201, 301 are arranged such that the resulting first and second channels 170, 180 are interconnected to each other such that, in use, cooling fluid flowing within the passage 130 flows in both the first and second channels 170, 180. Notably, as will be appreciated, the channels 170, 180 form the opposite internal sidewalls 140, 142 of the passage 130 and the catenulate shape thereof. In this embodiment, the sinusoidal splines 201, 301 crisscross each other and therefore the resulting channels 170, 180 are interconnected. The sinusoidal splines 201, 301 may not necessarily crisscross each other in other embodiments as will be described further below. As shown in Fig. 6, in this embodiment, the sinusoidal splines 201, 301 are symmetric about a linear axis extending in the longitudinal direction which, once the channels 170, 180 are formed, corresponds to the central linear axis CA. Thus, the sinusoidal splines 201, 301 oscillate about a common linear axis. As will be seen further below, this may not be the case in other embodiments.

The channels 170, 180 are milled using a milling cutter and have a relatively small width. For instance, in this example, the channels 170, 180 have a width of approximately 2 mm. Moreover, in this embodiment, each channel 170, 180 is formed by cutting into the surface 116 of the base 104 along the corresponding sinusoidal spline 201, 301. In other words, the milling cutter does not need to divert from either of the sinusoidal splines 201, 301 as it mills the respective channels 170, 180. For instance, each of the channels 170, 180 could be formed by milling along the corresponding sinusoidal spline 201, 301 a single time (i.e., in a single pass along each sinusoidal spline 201, 301). In some cases where the height of the channels 170, 180 is more significant (e.g., greater than the widths of the channels 170, 180), additional passes may be made at a different height following the same paths described by the sinusoidal splines 201, 301. Notably, in this embodiment, the width of each channel 170, 180 corresponds to the diameter of the milling cutter. Milling the channels 170, 180 is relatively simple as it does not require extensive tooling as might be the case for example for forming "micro" passages that have a microscopic width (e.g., 0.5 mm). Indeed, milling micro passages that are less than 1 mm wide can require more specialized tooling (e.g., a micro mill and associated micro milling cutters) and, moreover, typically requires significantly more passes to mill to a desired depth since the milling cutters cannot safely and/or cleanly cut a thickness of material that is deeper than the diameter of the milling cutter. In addition, micro milling cutters can have a greater tendency to break during use.

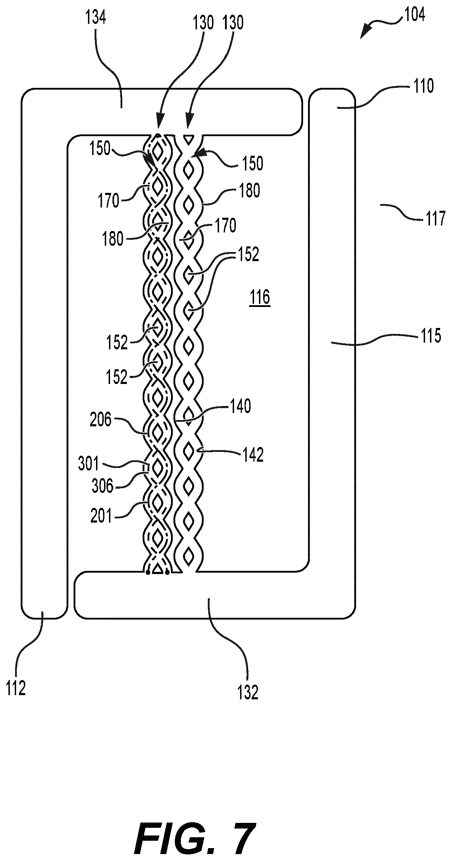

As shown in Fig. 7, once the first passage 130 is formed, a second passage 130 adjacent to the first passage 130 is formed. The second passage 130 is formed in the same manner as the first passage 130 as described above. Of course, it is contemplated that, in some embodiments, only a single passage 130 could be formed. As shown in Fig. 7, in this embodiment, the sinusoidal splines 201, 301 along which the channels 170, 180 forming the second passage 130 are milled are positioned such that the pins 152 of the pin row 150 defining the second passage 130 are offset in the longitudinal direction from the pins 152 defining the first passage 130. That is, a centerpoint of each pin 152 in the second pin row 150 is offset from a centerpoint of each pin 152 in the first pin row 150.

The other passages 130 of the fluid conduit 115 are then milled in the same manner as described above for the first two passages 130 until the finished base 104 is obtained.

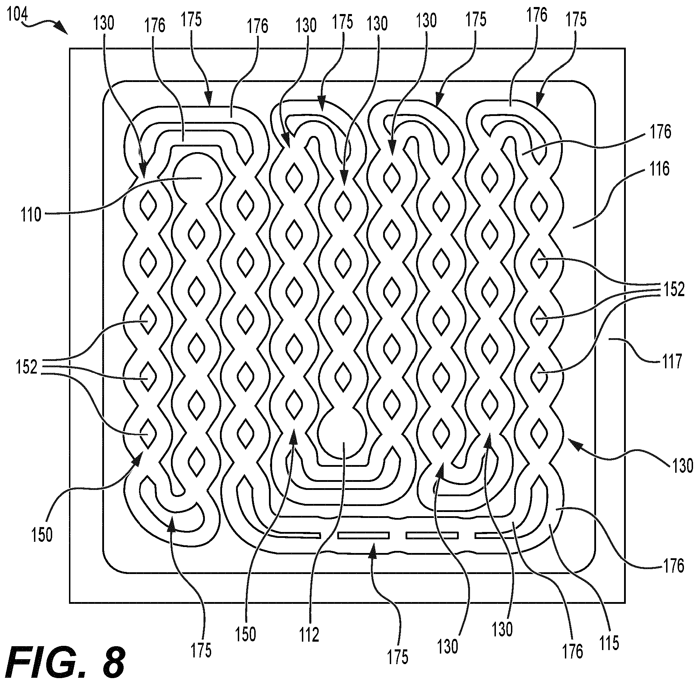

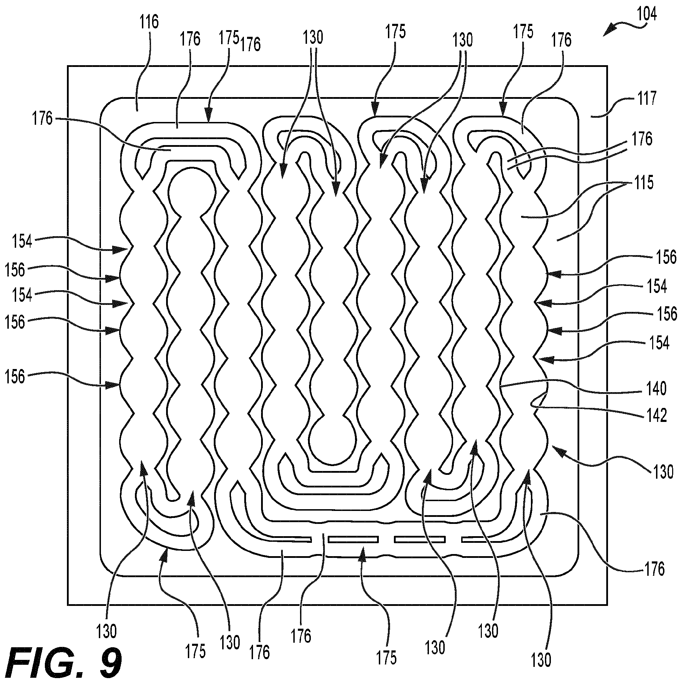

With reference to Fig. 8, in an alternative embodiment, the fluid conduit 115 could be configured differently and still have the passages 130 as described above. In particular, in Fig. 8, the base 104 is shaped differently and the fluid conduit 115 includes nine passages 130 extending parallel to each other. In this alternative embodiment, the passages 130 are fluidly connected to each other in series by interconnecting portions 175 of the fluid conduit 115. Notably, in this example, each interconnecting portion 175 is disposed between two consecutive passages 130 such that the cooling fluid flows into a given interconnecting portion 175 before flowing into another passage 130. In this alternative embodiment, each interconnecting portion 175 includes two parallel channels 176 through which the cooling fluid flows in parallel. The interconnecting portions 175 may be configured differently in other embodiments. The base 104 shown in Fig. 9 is manufactured in a manner similar to that described above.

As shown in Fig. 9, in another alternative embodiment, the pins 152 may be omitted. As can be seen, in this alternative embodiment, the base 104 is similar to that shown in Fig. 8 except that the pins 152 are not provided. Thus, in this example, each passage 130 is defined by the opposite internal sidewalls 140, 142 and includes the constricted portions 154 and the expanded portions 156 disposed alternatingly. In this embodiment, the base 104 is manufactured in a manner similar to that described above, however with the additional step of milling the base 104 to remove the pins 152 once the pins 152 are formed. For example, this could involve milling the base 104 along the central linear axis CA of each respective passage 130 such as to eliminate the pins 152.

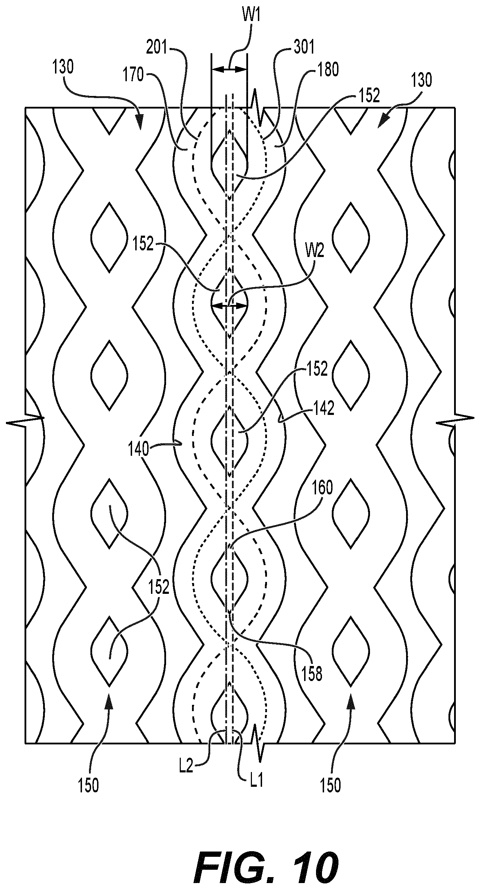

With reference to Fig. 10, in another alternative embodiment, the pins 152 of a given pin row 150 may be configured differently. For instance, in this alternative embodiment, the pins 152 of a given pin row 150 have different widths, namely two different widths. In particular, consecutive ones of the pins 152 of each pin row 150 have different widths measured along the lateral direction of the cooling block 100. Notably, for each two consecutive pins 152 of a pin row 150, a first pin 152 has a width W1 measured between the lateral ends of the pin 152, and a second pin 152 consecutive to the first pin 152 has a width W2 that is greater than the first width W1. Nevertheless, the pins 152 of the pin row 150 are symmetric about the central linear axis CA that bisects the passage 130. This can be achieved during manufacturing by slightly offsetting the sinusoidal splines 201, 301 corresponding to the channels 170, 180 so that the sinusoidal splines 201, 301 are centered about respective linear axes L1, L2 laterally spaced from each other and extending longitudinally (i.e., parallel to the central linear axis CA bisecting the width of the passage 130). This results in the corresponding pins 152 having the two different widths W1, W2. This configuration can cause a variation of the perturbations of the flow of cooling fluid caused by the pins 152 and may also enhance flow disturbances in the cooling fluid.

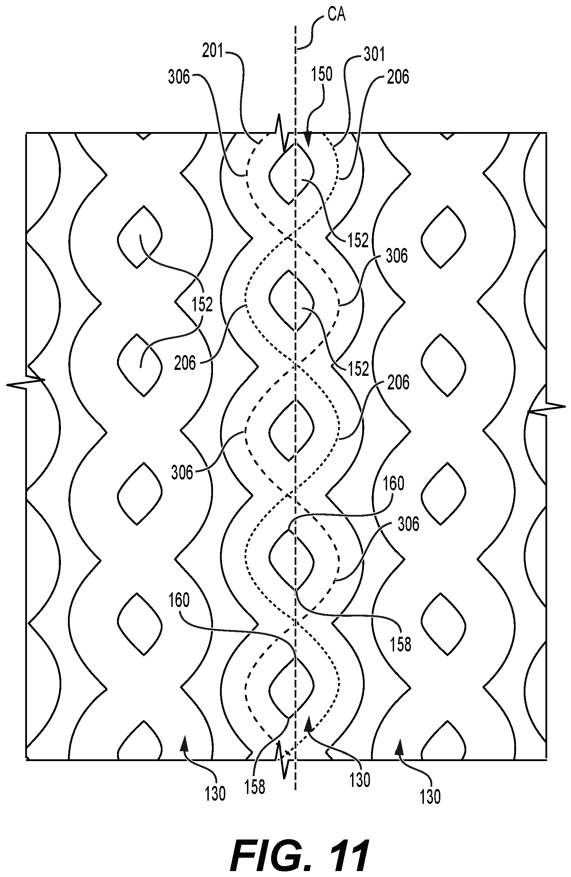

As shown in Fig. 11, in yet another alternative embodiment, the pins 152 of a given pin row 150 may be asymmetric about the central linear axis CA that bisects the width of the corresponding passage 130. In particular, in this example, the central linear axis CA traverses only one of the first and second pointed ends 158, 160 of each pin 152. More specifically, for each two consecutive pins 152 of a pin row 150, the central linear axis CA traverses a different one of the first and second pointed ends 158, 160 thereof. That is, for a given pin row 150, if the central linear axis CA traverses the first pointed end 158 of a first pin 152, the central linear axis CA traverses the second pointed end 160 of a second pin 152 consecutive to the first pin 152, and vice-versa. As can be seen, in this embodiment, consecutive ones of the pins 152 of the pin row 150 are nevertheless symmetric to each other about a plane normal to the linear axis and extending between the consecutive ones of the pins 152. This asymmetric configuration of the pins 152 can be achieved by ensuring that the sinusoidal splines 201, 301 are nearly but not completely out of phase with each other in the longitudinal direction. More specifically, in this embodiment, the sinusoidal splines 201, 301 are less than a quarter of a wavelength from being completely out of phase with each other. As will be appreciated, two sinusoidal splines are said to be completely out of phase with each other when they are 180° out of phase such that the peaks of one are aligned with the troughs of the other. This configuration can cause a variation of the perturbations of the flow of cooling fluid caused by the pins 152 and may also enhance flow disturbances in the cooling fluid.

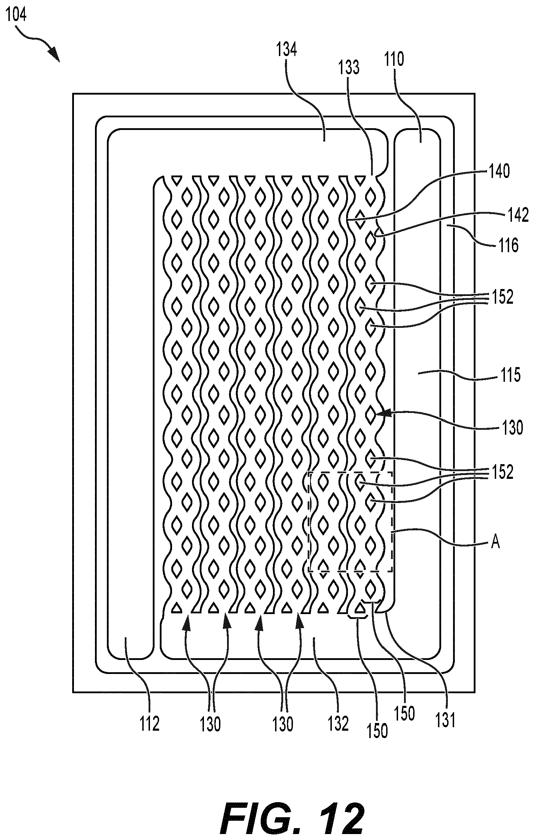

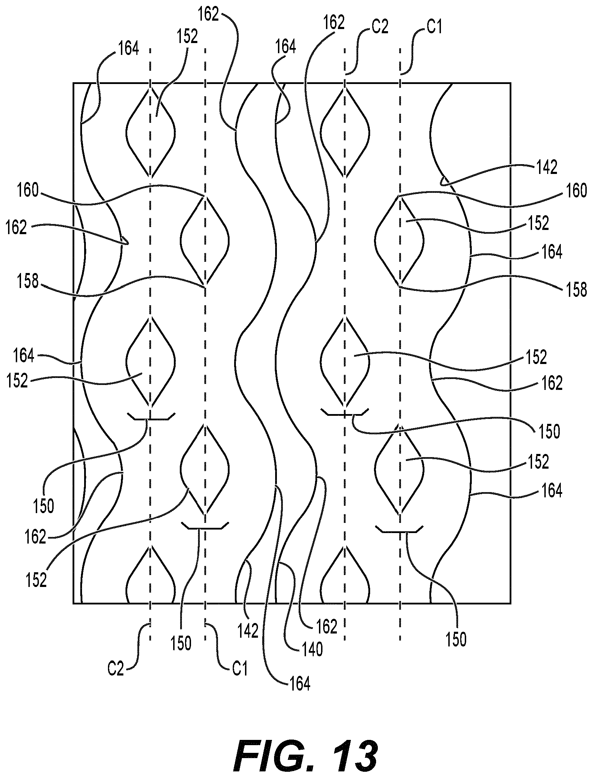

In some embodiments, each passage 130 may be defined by more than one pin row 150. Notably, with reference to Figs. 12 and 13, in another embodiment, each passage 130 is defined in part by first and second pin rows 150 disposed between the internal sidewalls 140, 142 of the passage 130. As shown in Fig. 13, in this example, for each pin row 150, the pins 152 thereof are laterally aligned with each other such that a corresponding linear axis C1, C2 extending in the longitudinal direction traverses each pin 152. The linear axes C1, C2 are laterally spaced from each other. In this example, each linear axis C1, C2 extends through both ends 158, 160 of each pin 152 of the corresponding pin row 150 as the pins 152 are symmetric about the respective linear axes C1, C2. In this embodiment, the pins 152 of the first pin row 150 are offset from the pins 152 of the second pin row 150 in the longitudinal direction.

It is contemplated that, in other embodiments, the pins 152 may be asymmetric as described above with regard to Fig. 11. In addition, in other embodiments, the pins 152 could have different widths as described above with regard to Fig. 10.

With reference to Fig. 13, in this embodiment, each internal sidewall 140, 142 has an undulating shape (i.e., a wave-like shape) and therefore has a plurality of rounded sections. More specifically, the rounded sections of each internal sidewall 140, 142 are a plurality of convex undulations 162 and a plurality of concave undulations 164 disposed alternatingly. Notably, each internal sidewall 140, 142 has a sinusoidal shape describing a sinusoidal function. As can be seen, in this embodiment, for each passage 130, the convex undulations 162 of the internal sidewall 140 are aligned, in the longitudinal direction, with the concave undulations 164 of the opposite internal sidewall 142 such that their respective peaks are longitudinally aligned. As such, the internal sidewalls 140, 142 defining each passage 130 are asymmetric about a central linear axis bisecting the width of the passage 130.

Furthermore, in the example of Fig. 13, for each two consecutive passages 130, the internal sidewall 140 defining a first passage 130 is adjacent to the internal sidewall 142 defining a second passage 130 consecutive to the first passage 130, and the concave undulations 164 of the internal sidewall 140 defining the first passage 130 are aligned, in the longitudinal direction, with the convex undulations 162 of the internal sidewall 142 defining the second passage 130. This may allow the passages 130 to be disposed closer to one another. Notably, the concave undulations 164 of the internal sidewall 140 defining the first passage 130 are partly aligned, in the lateral direction, with the concave undulations 164 of the internal sidewall 142 defining the second passage 130. The cooling efficiency of the cooling block 100 may be optimized by positioning the passages 130 closer to each other.

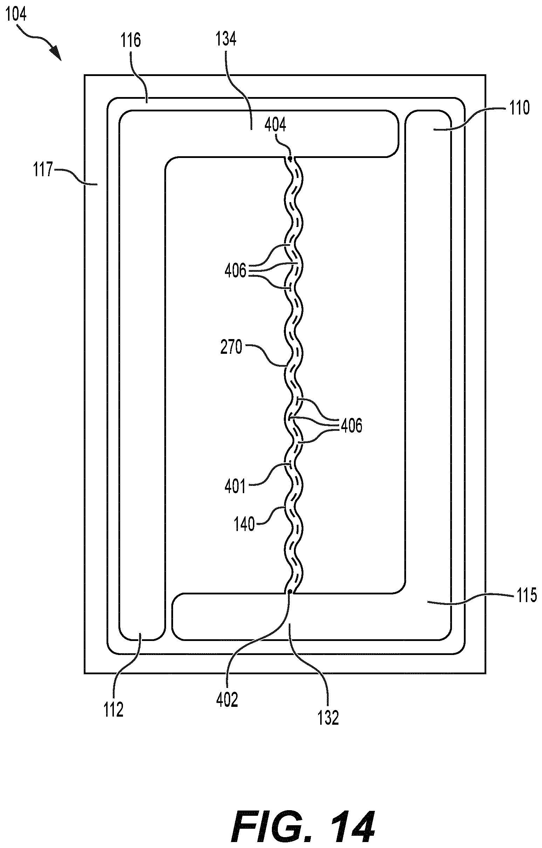

The manner in which the base 104 of Fig. 12 is manufactured will now be described with reference to Figs. 14 to 16 which illustrate the progressive forming of the passages 130. Similarly to that described above, the fluid conduit 115 is machined, namely milled, onto a piece of material to form the finished base 104. In this example, the inlet and outlet manifold portions 132, 134 are already formed prior to machining the passages 130. It is contemplated that the inlet and outlet manifold portions 132, 134 may not yet be formed prior to machining the passages 130. In other embodiments, the inlet and outlet manifold portions 132, 134 may even be entirely omitted. As shown in Fig. 14, in order to form a first passage 130, a first channel 270 is milled on the upper surface 116 of the base 104 following a path defined by a sinusoidal spline 401. The sinusoidal spline 401 extends in a longitudinal direction of the cooling block 100 from a first end 402 to a second end 404. In this embodiment, the first end 402 is located at an edge of the inlet manifold portion 132 and the second end 404 is located at an edge of the outlet manifold portion 134 such that the resulting first channel 270 interconnects the inlet and outlet manifold portions 132, 134. The sinusoidal spline 401 has the shape of a sinusoidal function, therefore oscillating periodically at a given amplitude and defining a plurality of peaks 406 at each half period thereof.

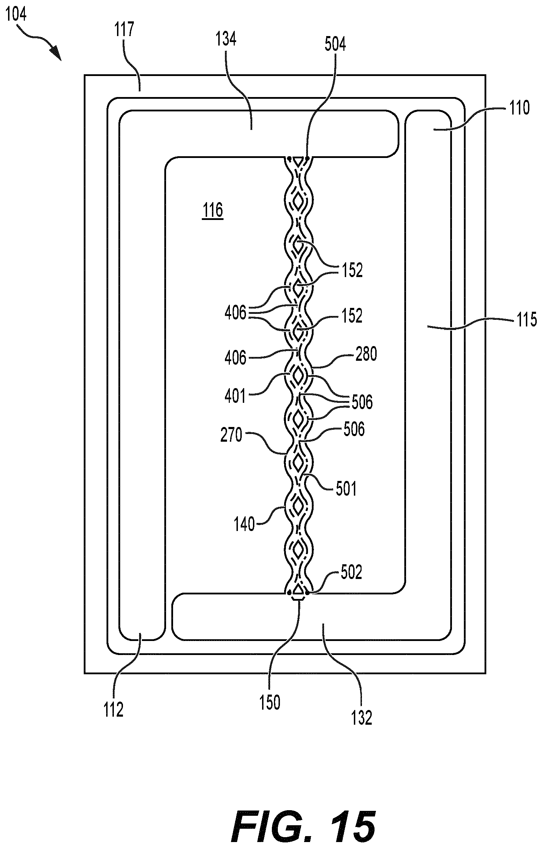

Next, as shown in Fig. 15, a second channel 280 is milled on the upper surface 116 of the base 104 following a path defined by another sinusoidal spline 501. The milling of the channels 270, 280 forms a first pin row 150 as described above. The sinusoidal spline 501 extends in the longitudinal direction of the cooling block 100 from a first end 502 to a second end 504. In this embodiment, the first end 502 is located at an edge of the inlet manifold portion 132 and the second end 504 is located at an edge of the outlet manifold portion 134 such that the resulting second channel 280 interconnects the inlet and outlet manifold portions 132, 134. The sinusoidal spline 501 has the shape of a sinusoidal function, therefore oscillating periodically at a given amplitude (namely the same amplitude as the sinusoidal spline 401) and defining a plurality of peaks 506 at each half period thereof. As will be appreciated, in this embodiment, the sinusoidal splines 401, 501 are centered (and oscillate) about different axes, namely two distinct linear axes extending in the longitudinal direction and spaced apart from each other in the lateral direction. The sinusoidal spline 501 is completely out of phase with the sinusoidal spline 401 (i.e., 180° out of phase along the longitudinal direction). Notably, the peaks 506 of the sinusoidal spline 501 are aligned, in the longitudinal direction, with the peaks 406 of the sinusoidal spline 401 and are symmetric to each other about a common linear axis (which, in this example, corresponds to the linear axis C1).

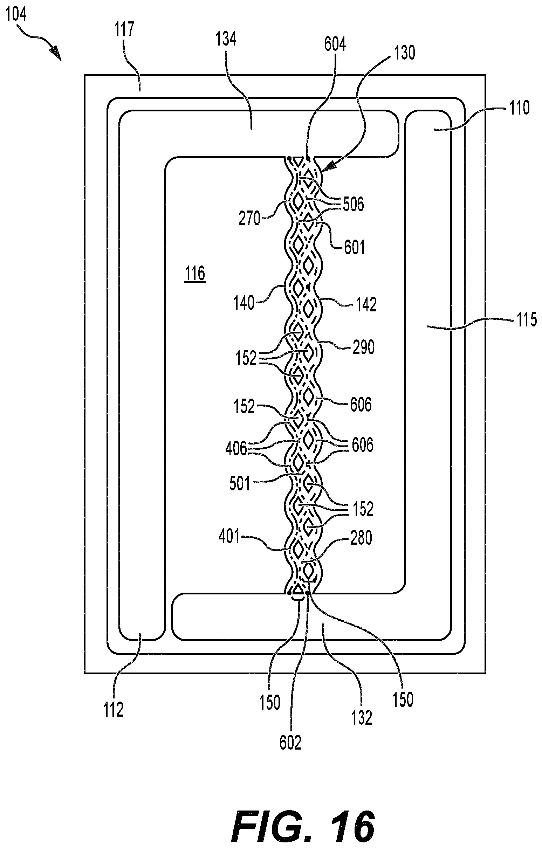

With reference to Fig. 16, after having milled the second channel 280, a third channel 290 is milled on the upper surface 116 of the base 104 following a path defined by another sinusoidal spline 601. In other embodiments, the channels 270, 280, 290 may be milled in a different order (e.g., the second channel 280 could be milled after the third channel 290). The milling of the third channel 290, combined with the milling of the second channel 280, forms a second pin row 150 as described above.

The sinusoidal spline 601 extends in the longitudinal direction of the cooling block 100 from a first end 602 to a second end 604. In this embodiment, the first end 602 is located at an edge of the inlet manifold portion 132 and the second end 604 is located at an edge of the outlet manifold portion 134 such that the resulting third channel 290 interconnects the inlet and outlet manifold portions 132, 134. The sinusoidal spline 601 has the shape of a sinusoidal function, therefore oscillating periodically at a given amplitude (namely the same amplitude as the sinusoidal splines 401, 501) and defining a plurality of peaks 606 at each half period thereof.

As will be appreciated, in this embodiment, the sinusoidal splines 401, 501, 601 are centered (and oscillate) about different axes, namely three distinct linear axes extending in the longitudinal direction and spaced apart from each other in the lateral direction. The sinusoidal spline 601 is completely out of phase with the sinusoidal spline 501 (i.e., 180° out of phase along the longitudinal direction) but in phase with the sinusoidal spline 401. Notably, the sinusoidal splines 501, 601 are symmetric to each other about a common linear axis (which, in this example, corresponds to the linear axis C2), however the sinusoidal splines 401, 601 are not symmetric to each other about a linear axis as the sinusoidal spline 601 is identical to the sinusoidal spline 401 but shifted relative thereto in the lateral direction.

Furthermore, in this embodiment, the sinusoidal spline 501, disposed between the sinusoidal splines 401, 601, partly overlaps the sinusoidal splines 401, 601. In particular, the peaks 506 of the sinusoidal spline 501 on one side of the linear axis about which the sinusoidal spline 501 is centered overlap the peaks 406 of the sinusoidal spline 401 that are longitudinally aligned therewith, and the peaks 506 of the sinusoidal spline 501 on an opposite side of the linear axis about which the sinusoidal spline 501 is centered overlap the peaks 606 of the sinusoidal spline 601 that are longitudinally aligned therewith.

As will be appreciated, in this embodiment, the amplitude of the sinusoidal splines 401, 501, 601 is equal to the distance between the linear axes C1, C2. Moreover, the amplitude of the sinusoidal splines 401, 501, 601 is equal to a sum of a radius of a milling cutter used for milling the channels 270, 280, 290 and half of the width of the pins 152.

After having milled all three channels 270, 280, 290, the first passage 130 of the fluid conduit 115 is formed. The other passages 130 are then formed in the same manner.

The channels 270, 280, 290 are milled using a milling cutter and have a relatively small width. For instance, in this example, the channels 270, 280, 290 have a width of approximately 2 mm. Moreover, in this embodiment, each channel 270, 280, 290 is formed by cutting into the surface 116 of the base 104 along the corresponding sinusoidal spline 401, 501, 601. In other words, the milling cutter does not need to divert from any of the sinusoidal splines 401, 501, 601 as it mills the respective channels 270, 280, 290. For instance, each of the channels 270, 280, 290 could be formed by milling along the corresponding sinusoidal spline 401, 501, 601 a single time (i.e., in a single pass along each sinusoidal spline 401, 501, 601). In some embodiments, more than a single pass along each sinusoidal spline 401, 501, 601 may be effected depending on the desired depth of the channels 270, 280, 290 . In this embodiment, the width of each channel 270, 280, 290 corresponds to the diameter of the milling cutter.

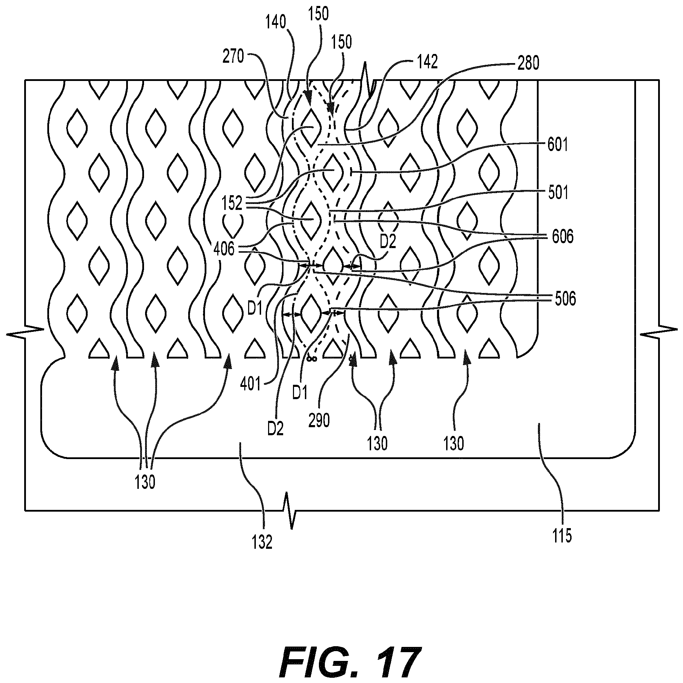

With reference to Fig. 17, in an alternative embodiment, the shape of the pins 152 is more elongated and the distance, in the longitudinal direction, between the pins 152 of a given pin row 150 can be made smaller. For instance, in this embodiment, a ratio of a distance between two consecutive pins 152 of a pin row 150 over a length of a pin 152 (between the ends 158, 160) is between 0.9 and 1.1. In particular, in this example, the ratio of a distance between two consecutive pins 152 of a pin row 150 over a length of a pin 152 is approximately 1. This ratio may be different in other examples. Moreover, in this embodiment, the pins 152 are spaced unequally from the internal sidewalls 140, 142. In particular, for each pin 152, a distance between the pin 152 and the internal sidewall 140 is different from a distance between the pin 152 and the opposite internal sidewall 142. In this embodiment, consecutive ones of the pins 152 defining the passage 130 are spaced further apart from one of the internal sidewalls 140, 142 alternatingly. That is, a first pin 152 of a first pin row 150 is spaced from the right internal sidewall 142 by a distance D1 and from the left internal sidewall 140 by a distance D2 (D1 being greater than D2), and a second pin 152 of the second pin row 150 that is consecutive in the longitudinal direction to the first pin 152 is spaced from the right internal sidewall 142 by the distance D2 and from the left internal sidewall 140 by the distance D1. The distance D2 (the smaller of the distances D1, D2) corresponds to the diameter of the milling cutter used to mill the channels 270, 280, 290. This configuration of the passages 130 and pins 152 are obtained when the sinusoidal splines 401, 501, 601 defining the paths that the milling cutter follows during machining of the channels 270, 280, 290 do not overlap each other. In particular, the amplitude of each of the sinusoidal splines 401, 501, 601 is smaller than a distance between consecutive ones of the linear axes about which the sinusoidal splines 401, 501, 601 are centered. This configuration can cause a variation of the perturbations of the flow of cooling fluid caused by the pins 152 and may also enhance flow disturbances in the cooling fluid.

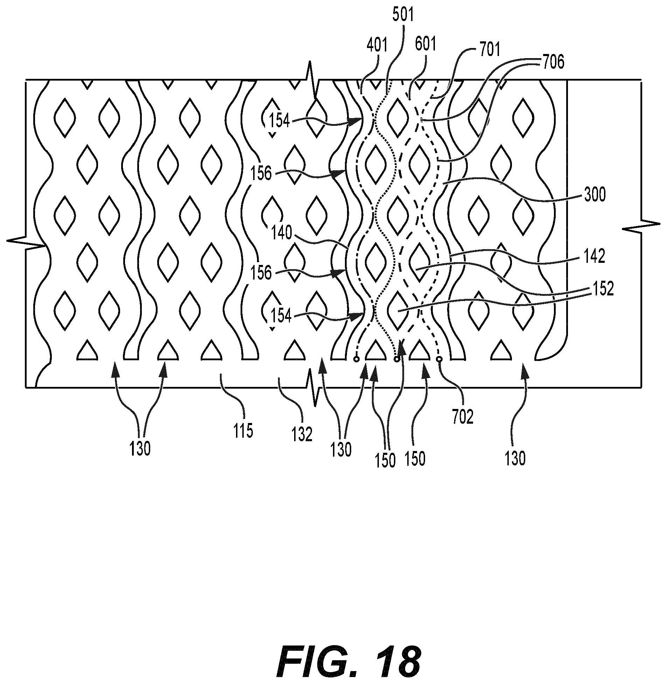

With reference to Fig. 18, in an alternative embodiment, each passage 130 could be defined in part by three pin rows 150. For each pin row 150, the pins 152 thereof are aligned in the lateral direction such that a respective linear axis traverses the pins 152 of the pin row 150. For each two consecutive pin rows 150 defining the passage 130 (i.e., the pin rows 150 consecutive to each other in the lateral direction), the pins 152 of a first pin row 150 are offset in the longitudinal direction from the pins 152 of a second pin row 150 consecutive to the first pin row 150. As can be seen, in this embodiment, when the number of the pin rows 150 is odd (as opposed to even), the internal sidewalls 140, 142 of the passage 130 are symmetric to each other about a central linear axis extending longitudinally and bisecting the width of the passage 130. Furthermore, each passage 130 includes the constricted portions 154 and the expanded portions 156 disposed alternatingly, whereby the expanded portions 156 have a width (measured in the lateral direction) greater than that of the constricted portions 154. The pins 152 of the two "outer" pin rows 150 that are closest to the internal sidewalls 140, 142 are disposed in the expanded portions 156, while the pins 152 of the "inner" pin row 150 disposed between the two outer pin rows 150 are disposed in the constricted portions 154.

As shown in Fig. 18, this configuration of the passages 130 can be obtained by forming a fourth channel 300 interconnected with the other channels 270, 280, 290. In particular, the fourth channel 300 is milled on the upper surface 116 of the base 104 following a path defined by another sinusoidal spline 701. The milling of the fourth channel 300, combined with the milling of the third channel 290, forms a third pin row 150 of the type described above. The sinusoidal spline 701 has the same configuration as the sinusoidal spline 501 and therefore will not be described in detail herein. As will be appreciated, the sinusoidal spline 701 has the shape of a sinusoidal function, therefore oscillating periodically at a given amplitude (namely the same amplitude as the sinusoidal splines 401, 501, 601) and defining a plurality of peaks 706 at each half period thereof. The peaks 706 of the sinusoidal spline 701 on an inner side of the linear axis about which the sinusoidal spline 701 is centered overlap the peaks 606 of the sinusoidal spline 601.

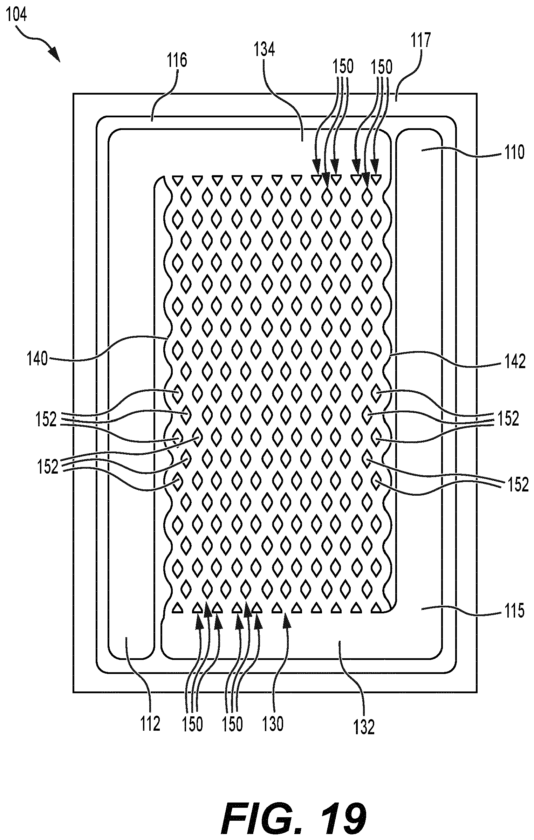

The passages 130 could be defined by any number of pin rows 150 in other embodiments. For instance, as shown in Fig. 19, in an alternative embodiment, a passage 130 of the fluid conduit 115 is defined by twenty-one pin rows 150, the pins 152 of each pin row 150 being centered about a respective linear axis that traverses each pin 152 of the respective pin row 150. Moreover, as can be seen, in this alternative embodiment, the fluid conduit 115 has a single passage 130 such that an entire proportion of the cooling fluid flows from the inlet manifold portion 132 to the outlet manifold portion 134 via the single passage 130.

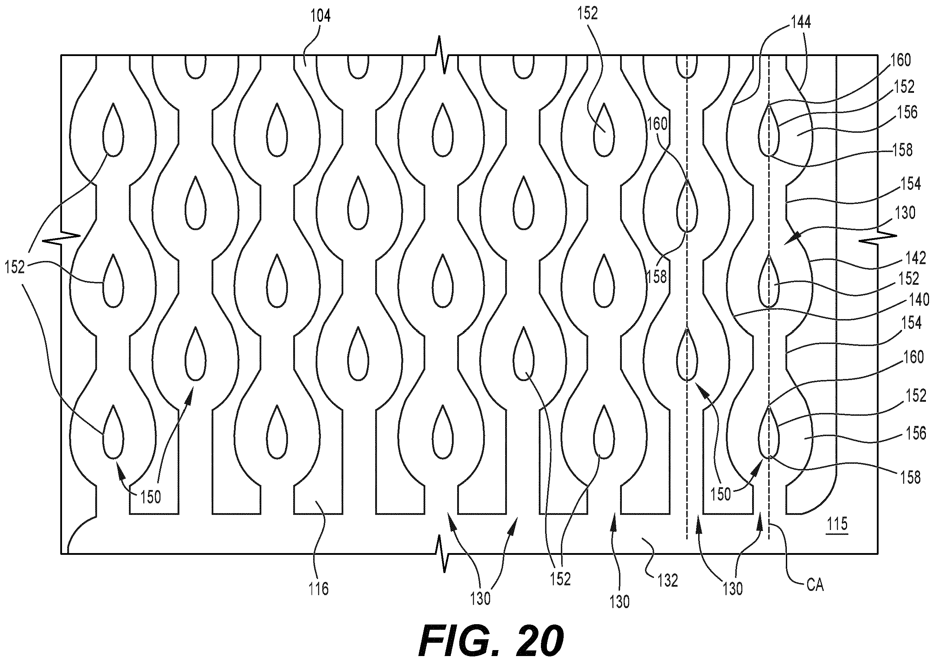

While the pins 152 described herein have been illustrated to have a same general shape, the pins 152 could also be shaped differently in other embodiments. For instance, with reference to Fig. 20 which illustrates parts of multiple passages 130 extending between the inlet and outlet manifold portions 132, 134, in an alternative embodiment, each pin 152 has a lacrimiform shape (which could also be referred to as an airfoil shape). That is, each pin 152 has a lacrimiform profile observed along a plane parallel to the thermal transfer surface 108 and traversing the pin 152. The term "lacrimiform" as defined herein encompasses all shapes generally resembling a tear-drop, including symmetric and asymmetric variations thereof. In this embodiment, the leading end 158 of each pin 152 is rounded and the trailing end 160 is pointed. The pins 152 are oriented such that the pointed end 160 is disposed downstream of the rounded end 158. As such, for each pin 152, the flow of cooling fluid reaches the rounded leading end 158 before it reaches the pointed trailing end 160. In this example, for a given pin row 150, each pin 152 is symmetric about a linear axis which traverses the rounded end 158 and the pointed end 160 of the pins 152 of the pin row 150. In particular, in this example, the central linear axis CA that bisects the passage 130 traverses the rounded ends 158 and pointed ends 160 of each pin 152 of the pin row 150. As will be described further below, the pins 152 may have a lacrimiform shape and be asymmetric in other embodiments.

With continued reference to Fig. 20, in this embodiment, the shape of the expanded portions 156 of each passage 130 is similar to that of the pins 152 which are disposed along the expanded portions 156. In this example, each expanded portion 156 is formed by two rounded sections 144 of the internal sidewalls 140, 142. In particular, for each passage 130, each rounded section 144 of the internal sidewalls 140, 142 is aligned, along the longitudinal direction, with a corresponding pin 152 of the pin row 150. In this example, each rounded section 144 has a similar shape as a portion of the corresponding pin 152 such that a spacing between the rounded section 144 and the portion of the corresponding pin 152 is constant. As such, in this embodiment, the internal sidewalls 140, 142 of a given passage 130 are symmetric to each other about the corresponding central linear axis CA. As shown in Fig. 20, in this example, the constricted portions 154 of the passage 130 are formed by rectilinear sections of the internal walls 140, 142.

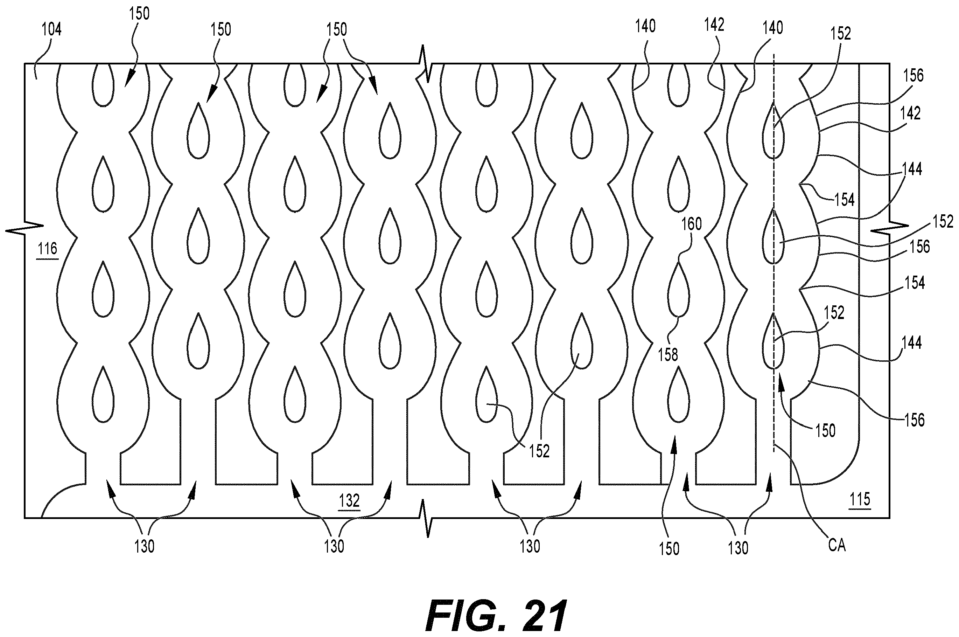

As shown in Fig. 21, in some embodiments, the lacrimiform pins 152 could be disposed closer to one another than shown in Fig. 20. Notably, in the examples of Fig. 21, the constricted portions 154 of the passages 130 correspond to the ends of the rounded sections 144 of the internal sidewalls 140, 142. In these embodiments, the distance between the trailing end 160 of each pin 152 and the leading edge 158 of each consecutive one of the pin row 150 can be identical to the spacing between the rounded sections 144 and the corresponding pins 152. As will be appreciated, in these embodiments, the internal sidewalls 140, 142 are scalloped.

While the lacrimiform pins 152 are shown here as being disposed in parallel passages 130 defined between the inlet and outlet manifold portions 132, 134, it is contemplated that the passages 130 defined by the lacrimiform pins 152 could instead be fluidly connected in series such as in the embodiment of Fig. 8 for example. Furthermore, in some embodiments, each passage 130 could have more than one pin row 150 of the lacrimiform pins 152 such as in the embodiments of Figs. 12, 18 and 19.

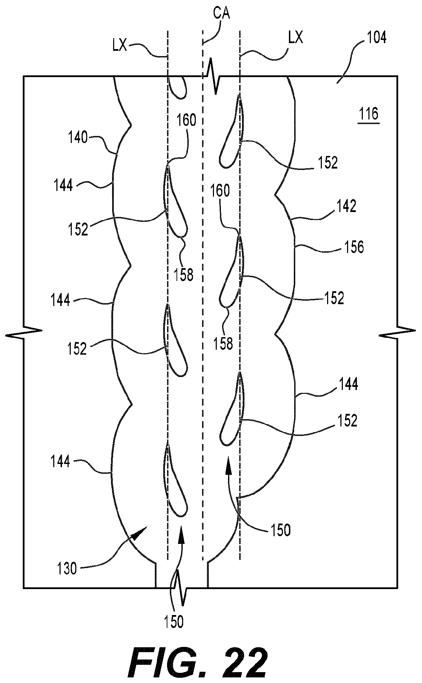

In another alternative embodiment, the lacrimiform pins 152 are configured to be asymmetric. For instance, as shown in Fig. 22, in this alternative embodiment, each passage 130 is defined in part by two pin rows 150 including multiple ones of the lacrimiform pins 152. The pins 152 of consecutive ones of the pin rows 150 are offset from each other along the longitudinal direction. Notably, a centerpoint of each pin 152 of a first pin row 150 (located at midlength between the opposite ends 158, 160 of the pin 152) is offset from the centerpoint of each pin 152 of a second pin row 150 that is consecutive to the first pin row 150. A linear axis LX extending longitudinally can be traced to traverse each pin 152 of a respective pin row 150. In particular, each linear axis LX traverses the pointed trailing end 160 of each pin 152 of the corresponding pin row 150. The linear axes LX of the two pin rows 150 are spaced apart from each other in the lateral direction. However, as will be appreciated, each pin 152 is asymmetric about the linear axis LX of its corresponding pin row 150. Indeed, in this embodiment, the linear axes LX do not extend through the rounded leading ends 158 of the pins 152. Moreover, in this example, the pins 152 are shaped and oriented such that the rounded ends 158 of the pins 152 of two consecutive pin rows 150 are closer to each other than the pointed ends 160 of the pins 152 of the two consecutive pin rows 150. In other words, a distance between the rounded end 158 of a pin 152 of a first pin row 150 and the rounded end 158 of a pin 152 of a second pin row 150 is less than a distance between the pointed ends 160 of these same pins 152. In particular, in this example, the shape of the pins 152 of the first pin row 150 is a mirror image of the shape of the pins 152 of the second pin row 150. However, as will be appreciated, in this embodiment, the central linear axis CA that bisects the width of the passage 130 extends between the two pin rows 150 and is spaced from the pins 152 of each pin row 150 by equal distances.

The lacrimiform shape of the pins 152 can promote flow disturbances in the flow of cooling fluid, notably increasing turbulent flow and limiting flow separation. This is particularly evident in comparison to conventional pin shapes such as circular or elliptical pins. As will be appreciated, many of the configurations discussed above are also applicable to the lacrimiform pins 152.

The passages 130 that are defined by the lacrimiform pins 152 can be machined on the base 104 via a milling operation using a milling cutter.

Modifications and improvements to the above-described embodiments of the present technology may become apparent to those skilled in the art. The foregoing description is intended to be exemplary rather than limiting. The scope of the present technology is therefore intended to be limited solely by the scope of the appended claims.

## Claims

1. A cooling block (100) for cooling a heat-generating electronic component (50), comprising:
a body (102) having a thermal transfer surface (108) configured to be placed in thermal contact with the heat-generating electronic component,
the body defining a fluid conduit (115) for circulating a cooling fluid therein, the fluid conduit having an inlet (110) for receiving the cooling fluid and an outlet (112) for discharging the cooling fluid,
the body comprising a plurality of pins (150) for deflecting the cooling fluid within the fluid conduit;
the fluid conduit comprising a plurality of passages (130) extending from a first point (131) to a second point (133) along a longitudinal direction of the cooling block, the second point being downstream from the first point,
wherein, for each passage of the plurality of passages:
the passage is defined in part by first and second internal sidewalls (140, 142) extending from the first point to the second point, each internal sidewall of the first and second internal sidewalls having a scalloped or undulating shape such that the internal sidewall comprises a plurality of rounded sections (144, 162, 164), a width of the passage being measured between the first and second internal sidewalls in a lateral direction normal to the longitudinal direction;
the passage is defined in part by at least one pin row (150) disposed between the first and second internal sidewalls, each pin row of the at least one pin row including multiple pins of the plurality of pins,
for each pin row of the at least one pin row, the pins of the pin row being spaced apart along the longitudinal direction and being aligned with each other in the lateral direction such that a linear pin axis extending in the longitudinal direction traverses each pin of the pin row, the first and second internal sidewalls being disposed on opposite sides of the linear pin axis;
**characterized in that**:
for each pair of consecutive passages:
first rounded sections on the first internal sidewall of a first passage are offset along the longitudinal direction from second rounded sections on the second internal sidewall of a second passage, and
third rounded sections on the second internal sidewall of the first passage are offset along the longitudinal direction from fourth rounded sections on the first internal sidewall of the second passage.

2. The cooling block of claim 1, wherein each pin of the at least one pin row has a lanceolate profile.

3. The cooling block of claim 2, wherein the pins of each pin row are symmetric about the corresponding linear pin axis.

4. The cooling block of any one of claims 1 to 3, wherein:
the at least one pin row is a single pin row;
the first and second internal sidewalls are symmetric about the linear pin axis; and
each passage of the plurality of passages is catenulate.

5. The cooling block of claim 4, wherein:
each passage of the plurality of passages comprises a plurality of constricted portions and a plurality of expanded portions;
the constricted portions have a first width measured in the lateral direction;
the expanded portions have a second width measured in the lateral direction, the second width being greater than the first width; and
the constricted and expanded portions are disposed alternatingly in the longitudinal direction.

6. The cooling block of any one of claims 1 to 5, wherein consecutive ones of the pins of each pin row have different widths measured along the lateral direction.

7. The cooling block of any one of claims 1 to 6, wherein, for each pin row of the at least one pin row:
each pin has a first pointed end and a second pointed end;
the linear pin axis extends through one of the first pointed end and the second pointed end of each pin;
the pins of the pin row are asymmetric about the linear pin axis; and
consecutive ones of the pins of the pin row are symmetric to each other about a plane normal to the linear axis and extending between the consecutive ones of the pins.

8. The cooling block of any one of claims 1 to 7, wherein:
the at least one pin row is a single pin row;
the linear pin axis of the pin row defining the first passage is parallel to the linear pin axis of the pin row defining the second passage; and
the pins of the pin row defining the second passage are offset, in the longitudinal direction, from the pins of the pin row defining the first passage.

9. The cooling block of any one of claims 1 to 3, wherein, for each passage of the plurality of passages:
the at least one pin row is a plurality of pin rows;
each internal sidewall of the first and second internal sidewalls has an undulating shape; and
each internal sidewall of the first and second internal sidewalls comprises a plurality of convex undulations (162) and a plurality of concave undulations (164) disposed alternatingly;
the concave undulations of the first internal sidewall are aligned, in the longitudinal direction, with the convex undulations of the second internal sidewall; and
the concave undulations of the second internal sidewall are aligned, in the longitudinal direction, with the convex undulations of the first internal sidewall.

10. The cooling block of claim 9, wherein:
the second internal sidewall defining the first passage is adjacent to the first internal sidewall defining the second passage;
the concave undulations of the second internal sidewall defining the first passage are aligned in the longitudinal direction with the convex undulations of the first internal sidewall defining the second passage; and
the concave undulations of the second internal sidewall defining the first passage are partly aligned, in the lateral direction, with the concave undulations of the first internal sidewall defining the second passage.

11. The cooling block of any one of claims 1 to 3, wherein, for each passage of the plurality of passages:
the at least one pin row is a plurality of pin rows; and
for each two consecutive pin rows of the plurality of pin rows:
the linear axis traversing the pins of a first one of the two consecutive pin rows is parallel to the linear axis traversing the pins of a second one of the two consecutive pin rows; and
the pins of the first one of the two consecutive pin rows are offset, in the longitudinal direction, from the pins of the second one of the two consecutive pin rows.

12. The cooling block of claim 11, wherein:
the plurality of pin rows includes first, second and third pin rows, the second pin row being disposed between the first and third pin rows along the lateral direction;
each passage of the plurality of passages comprises a plurality of constricted portions and a plurality of expanded portions;
the constricted portions have a first width measured in the lateral direction;
the expanded portions have a second width measured in the lateral direction, the second width being greater than the first width;
the constricted and expanded portions are disposed alternatingly in the longitudinal direction;
the pins of the second pin row are disposed at the constricted portions of each passage of the plurality of passages; and
the pins of the first and third pin rows are disposed at the expanded portions of each passage of the plurality of passages.

13. A method for manufacturing a cooling block configured to cool a heat-generating electronic component, the method comprising:
providing a base for forming part of the cooling block;
forming each passage of a plurality of passages of a fluid conduit of the cooling block by:
milling a first channel on a surface of the base following a path defined by a first sinusoidal spline; and
milling a second channel on the surface of the base following a path defined by a second sinusoidal spline,
the first and second sinusoidal splines extending in a longitudinal direction of the cooling block and being arranged such that the first channel and the second channel are interconnected to each other such that, in use, cooling fluid flowing within the passage flows within the first channel and the second channel;
said milling of the first and second channels forming a pin row comprising a plurality of pins aligned such that a linear pin axis extending in the longitudinal direction traverses each pin of the pin row, the pins of the pin row being spaced from each other along the longitudinal direction;
each passage being defined by said milling of the first and second channels forming first and second internal sidewalls (140, 142) extending in the longitudinal direction of the cooling block such that each internal sidewall comprises a plurality of rounded sections (144, 162, 164);
wherein the first and second channels for each pair of consecutive passages are milled so that:
first rounded sections on the first internal sidewall of a first passage are offset along the longitudinal direction from second rounded sections on the second internal sidewall of a second passage, and
third rounded sections on the second internal sidewall of the first passage are offset along the longitudinal direction from fourth rounded sections on the first internal sidewall of the second passage.

14. The method of claim 13, wherein the first sinusoidal spline and the second sinusoidal spline are symmetric about the linear pin axis.

15. The method of claim 13, wherein:
the first sinusoidal spline extends from a first end to a second end;
the second sinusoidal spline extends from a first end to a second end; and
the first end of the first sinusoidal spline and the first end of the second sinusoidal spline are coincident.

## Patentansprüche

1. Kühlblock (100) zur Kühlung eines wärmeerzeugenden elektronischen Bauteils (50), umfassend:
einen Körper (102), der eine Wärmeübertragungsfläche (108) aufweist, die dazu konfiguriert ist, in thermischem Kontakt mit dem wärmeerzeugenden elektronischen Bauteil platziert zu sein,
wobei der Körper eine Fluidleitung (115) zum Zirkulieren eines Kühlfluids darin definiert, wobei die Fluidleitung einen Einlass (110) zum Aufnehmen des Kühlfluids und einen Auslass (112) zum Abgeben des Kühlfluids aufweist,
wobei der Körper eine Vielzahl von Stiften (150) zum Umlenken des Kühlfluids innerhalb der Fluidleitung umfasst;
wobei die Fluidleitung eine Vielzahl von Durchgängen (130) umfasst, die sich von einem ersten Punkt (131) zu einem zweiten Punkt (133) entlang einer Längsrichtung des Kühlblocks erstreckt, wobei der zweite Punkt stromabwärts von dem ersten Punkt liegt,
wobei für jeden Durchgang der Vielzahl von Durchgängen:
der Durchgang teilweise durch eine erste und eine zweite innere Seitenwand (140, 142) definiert ist, die sich von dem ersten Punkt zu dem zweiten Punkt erstrecken, wobei jede innere Seitenwand der ersten und der zweiten inneren Seitenwand eine wellenförmige oder gewellte Form aufweist, sodass die innere Seitenwand eine Vielzahl von abgerundeten Bereichen (144, 162, 164) umfasst, wobei eine Breite des Durchgangs zwischen der ersten und der zweiten inneren Seitenwand in einer Querrichtung senkrecht zu der Längsrichtung gemessen wird;
der Durchgang teilweise durch mindestens eine Stiftreihe (150) definiert ist, die zwischen der ersten und der zweiten inneren Seitenwand angeordnet ist, wobei jede Stiftreihe der mindestens einen Stiftreihe mehrere Stifte der Vielzahl von Stiften beinhaltet,
wobei für jede Stiftreihe der mindestens einen Stiftreihe die Stifte der Stiftreihe entlang der Längsrichtung voneinander beabstandet sind und in der Querrichtung derart aneinander ausgerichtet sind, dass eine lineare Stiftachse, die sich in der Längsrichtung erstreckt, jeden Stift der Stiftreihe durchquert, wobei die erste und zweite innere Seitenwand auf gegenüberliegenden Seiten der linearen Stiftachse angeordnet sind;
**dadurch gekennzeichnet, dass**:
für jedes Paar von aufeinanderfolgenden Durchgängen:
erste abgerundete Bereiche an der ersten inneren Seitenwand eines ersten Durchgangs entlang der Längsrichtung gegenüber zweiten abgerundeten Bereichen an der zweiten inneren Seitenwand eines zweiten Durchgangs versetzt sind und
dritte abgerundete Bereiche an der zweiten inneren Seitenwand des ersten Durchgangs entlang der Längsrichtung gegenüber vierten abgerundeten Bereichen an der ersten inneren Seitenwand des zweiten Durchgangs versetzt sind.

2. Kühlblock nach Anspruch 1, wobei jeder Stift der mindestens einen Stiftreihe ein lanzettförmiges Profil aufweist.

3. Kühlblock nach Anspruch 2, wobei die Stifte jeder Stiftreihe um die entsprechende lineare Stiftachse symmetrisch sind.

4. Kühlblock nach einem der Ansprüche 1 bis 3, wobei:
die mindestens eine Stiftreihe eine einzelne Stiftreihe ist;
die erste und die zweite innere Seitenwand um die lineare Stiftachse symmetrisch sind; und
jeder Durchgang der Vielzahl von Durchgängen kettenförmig ist.

5. Kühlblock nach Anspruch 4, wobei:
jeder Durchgang der Vielzahl von Durchgängen eine Vielzahl von verengten Abschnitten und eine Vielzahl von aufgeweiteten Abschnitten umfasst;
die verengten Abschnitte eine in der Querrichtung gemessene erste Breite aufweisen;
die aufgeweiteten Abschnitte eine in der Querrichtung gemessene zweite Breite aufweisen, wobei die zweite Breite größer ist als die erste Breite; und
die verengten und die aufgeweiteten Abschnitte abwechselnd in der Längsrichtung angeordnet ist.

6. Kühlblock nach einem der Ansprüche 1 bis 5, wobei aufeinanderfolgende der Stifte jeder Stiftreihe unterschiedliche entlang der Querrichtung gemessene Breiten aufweisen.

7. Kühlblock nach einem der Ansprüche 1 bis 6, wobei für jede Stiftreihe der mindestens einen Stiftreihe:
jeder Stift ein erstes spitzes Ende und ein zweites spitzes Ende aufweist;
sich die lineare Stiftachse durch eines von dem ersten spitzen Ende und dem zweiten spitzen Ende jedes Stifts erstreckt;
die Stifte der Stiftreihe um die lineare Stiftachse asymmetrisch sind; und
aufeinanderfolgende der Stifte der Stiftreihe um eine Ebene, die senkrecht zu der linearen Achse liegt und sich zwischen den aufeinanderfolgenden der Stifte erstreckt, symmetrisch zueinander sind.

8. Kühlblock nach einem der Ansprüche 1 bis 7, wobei:
die mindestens eine Stiftreihe eine einzelne Stiftreihe ist;
die lineare Stiftachse der Stiftreihe, die den ersten Durchgang definiert, parallel zu der linearen Stiftachse der Stiftreihe ist, die den zweiten Durchgang definiert; und
die Stifte der Stiftreihe, die den zweiten Durchgang definiert, in der Längsrichtung gegenüber den Stiften der Stiftreihe, die den ersten Durchgang definiert, versetzt sind.

9. Kühlblock nach einem der Ansprüche 1 bis 3, wobei für jeden Durchgang der Vielzahl von Durchgängen:
die mindestens eine Stiftreihe eine Vielzahl von Stiftreihen ist;
jede innere Seitenwand der ersten und der zweiten inneren Seitenwand eine gewellte Form aufweist; und
jede innere Seitenwand der ersten und der zweiten inneren Seitenwand eine Vielzahl von konvexen Wellen (162) und eine Vielzahl von konkaven Wellen (164) umfasst, die abwechselnd angeordnet sind;
die konkaven Wellen der ersten inneren Seitenwand in der Längsrichtung mit den konvexen Wellen der zweiten inneren Seitenwand ausgerichtet sind; und
die konkaven Wellen der zweiten inneren Seitenwand in der Längsrichtung mit den konvexen Wellen der ersten inneren Seitenwand ausgerichtet sind.

10. Kühlblock nach Anspruch 9, wobei:
die zweite innere Seitenwand, die den ersten Durchgang definiert, benachbart zu der ersten inneren Seitenwand ist, die den zweiten Durchgang definiert;
die konkaven Wellen der zweiten inneren Seitenwand, die den ersten Durchgang definiert, in der Längsrichtung mit den konvexen Wellen der ersten inneren Seitenwand, die den zweiten Durchgang definiert, ausgerichtet sind; und
die konkaven Wellen der zweiten inneren Seitenwand, die den ersten Durchgang definiert, in der Querrichtung teilweise mit den konkaven Wellen der ersten inneren Seitenwand, die den zweiten Durchgang definiert, ausgerichtet sind.

11. Kühlblock nach einem der Ansprüche 1 bis 3, wobei für jeden Durchgang der Vielzahl von Durchgängen:
die mindestens eine Stiftreihe eine Vielzahl von Stiftreihen ist; und
für jeweils zwei aufeinanderfolgende Stiftreihen der Vielzahl von Stiftreihen:
die lineare Achse, welche die Stifte einer ersten der zwei aufeinanderfolgenden Stiftreihen durchquert, parallel zu der linearen Achse ist, welche die Stifte einer zweiten der zwei aufeinanderfolgenden Stiftreihen durchquert; und
die Stifte der ersten der zwei aufeinanderfolgenden Stiftreihen in der Längsrichtung gegenüber den Stiften der zweiten der zwei aufeinanderfolgenden Stiftreihen versetzt sind.

12. Kühlblock nach Anspruch 11, wobei:
die Vielzahl von Stiftreihen eine erste, eine zweite und eine dritte Stiftreihe beinhaltet, wobei die zweite Stiftreihe entlang der Querrichtung zwischen der ersten und der dritten Stiftreihe angeordnet ist;
jeder Durchgang der Vielzahl von Durchgängen eine Vielzahl von verengten Abschnitten und eine Vielzahl von aufgeweiteten Abschnitten umfasst;
die verengten Abschnitte eine in der Querrichtung gemessene erste Breite aufweisen;
die aufgeweiteten Abschnitte eine in der Querrichtung gemessene zweite Breite aufweisen, wobei die zweite Breite größer ist als die erste Breite;
die verengten und die aufgeweiteten Abschnitte abwechselnd in der Längsrichtung angeordnet ist;
die Stifte der zweiten Stiftreihe an den verengten Abschnitten jedes Durchgangs der Vielzahl von Durchgängen angeordnet sind; und
die Stifte der ersten und der dritten Stiftreihe an den aufgeweiteten Abschnitten jedes Durchgangs der Vielzahl von Durchgängen angeordnet sind.

13. Verfahren zum Herstellen eines Kühlblocks, der dazu konfiguriert ist, ein wärmeerzeugendes elektronisches Bauteil zu kühlen, wobei das Verfahren Folgendes umfasst:
Bereitstellen einer Basis zum Bilden eines Teils des Kühlblocks;
Bilden jedes Durchgangs einer Vielzahl von Durchgängen einer Fluidleitung des Kühlblocks durch:
Fräsen eines ersten Kanals an einer Fläche der Basis, der einem durch einen ersten sinusförmigen Spline definierten Verlauf folgt; und
Fräsen eines zweiten Kanals an einer Fläche der Basis, der einem durch einen zweiten sinusförmigen Spline definierten Verlauf folgt,
wobei sich der erste und der zweite sinusförmige Spline in einer Längsrichtung des Kühlblocks erstrecken und derart angeordnet sind, dass der erste Kanal und der zweite Kanal derart miteinander verbunden sind, dass bei Verwendung das innerhalb des Durchgangs strömende Kühlfluid innerhalb des ersten Kanals und des zweiten Kanals strömt;
wobei das Fräsen des ersten und des zweiten Kanals eine Stiftreihe bildet, die eine Vielzahl von Stiften umfasst, die derart ausgerichtet ist, dass eine lineare Stiftachse, die sich in der Längsrichtung erstreckt, jeden Stift der Stiftreihe durchquert, wobei die Stifte der Stiftreihe entlang der Längsrichtung voneinander beabstandet sind;
wobei jeder Durchgang durch das Fräsen des ersten und des zweiten Kanals definiert wird, welche die erste und die zweite innere Seitenwand (140, 142) bilden, die sich in der Längsrichtung des Kühlblocks erstrecken, sodass jede innere Seitenwand eine Vielzahl von abgerundeten Bereichen (144, 162, 164) umfasst;
wobei der erste und der zweite Kanal für jedes Paar von aufeinanderfolgenden Durchgängen so gefräst werden, dass:
erste abgerundete Bereiche an der ersten inneren Seitenwand eines ersten Durchgangs entlang der Längsrichtung gegenüber zweiten abgerundeten Bereichen an der zweiten inneren Seitenwand eines zweiten Durchgangs versetzt sind und
dritte abgerundete Bereiche an der zweiten inneren Seitenwand des ersten Durchgangs entlang der Längsrichtung gegenüber vierten abgerundeten Bereichen an der ersten inneren Seitenwand des zweiten Durchgangs versetzt sind.

14. Verfahren nach Anspruch 13, wobei der erste sinusförmige Spline und der zweite sinusförmige Spline um die lineare Stiftachse symmetrisch sind.

15. Verfahren nach Anspruch 13, wobei:
sich der erste sinusförmige Spline von einem ersten Ende zu einem zweiten Ende erstreckt;
sich der zweite sinusförmige Spline von einem ersten Ende zu einem zweiten Ende erstreckt; und
das erste Ende des ersten sinusförmigen Splines und das erste Ende des zweiten sinusförmigen Splines übereinstimmen.

## Revendications

1. Bloc de refroidissement (100) pour refroidir un composant électronique générant de la chaleur (50), comprenant :
un corps (102) ayant une surface de transfert thermique (108) configuré pour être en contact thermique avec le composant électronique générant de la chaleur,
le corps définissant un conduit de fluide (115) pour faire circuler un fluide de refroidissement à travers celui-ci, le conduit de fluide ayant une entrée (110) pour recevoir le fluide de refroidissement et une sortie (112) pour évacuer le fluide de refroidissement,
le corps comprenant une pluralité de broches (150) pour dévier le fluide de refroidissement à l'intérieur du conduit de fluide ;
le conduit de fluide comprenant une pluralité de passages (130) se prolongeant à partir d'un premier point (131) à un second point (133) le long d'une direction longitudinale du bloc de refroidissement, le second point étant en aval à partir du premier point,
dans lequel, pour chaque passage de la pluralité de passages :
le passage est défini en partie par des première et seconde parois latérales internes (140, 142) se prolongeant à partir du premier point au second point, chaque paroi latérale interne des première et seconde parois latérales internes ayant une forme festonnée ou ondulée de telle sorte que la paroi latérale interne comprend une pluralité de sections arrondies (144, 162, 164), une largeur du passage étant mesurée entre les première et seconde parois latérales internes dans une direction latérale normale à la direction longitudinale ;
le passage est défini en partie par au moins une rangée de broches (150) disposée entre les première et seconde parois latérales internes, chaque rangée de broches de l'au moins une rangée de broches comportant plusieurs broches de la pluralité de broches,
pour chaque rangée de broches de l'au moins une rangée de broches, les broches de la rangée de broches étant espacées le long de la direction longitudinale et étant alignées les unes avec les autres dans la direction latérale de telle sorte qu'un axe de broche linéaire se prolongeant dans la direction longitudinale traverse chaque broche de la rangée de broches, les première et seconde parois latérales internes étant disposées sur des côtés opposés de l'axe de broche linéaire ;
**caractérisé en ce que** :
pour chaque paire de passages consécutifs :
les premières sections arrondies sur la première paroi latérale interne d'un premier passage sont décalées le long de la direction longitudinale par rapport aux deuxièmes sections arrondies sur la seconde paroi latérale interne d'un second passage, et
les troisièmes sections arrondies sur la seconde paroi latérale interne du premier passage sont décalées le long de la direction longitudinale par rapport aux quatrièmes sections arrondies sur la première paroi latérale interne du second passage.

2. Bloc de refroidissement selon la revendication 1, dans lequel chaque broche de l'au moins une rangée de broches présente un profil lancéolé.

3. Bloc de refroidissement selon la revendication 2, dans lequel les broches de chaque rangée de broches sont symétriques par rapport à l'axe de broche linéaire correspondant.

4. Bloc de refroidissement selon l'une quelconque des revendications 1 à 3, dans lequel :
l'au moins une rangée de broches est une rangée de broches unique ;
les première et seconde parois latérales internes sont symétriques par rapport à l'axe de la broche linéaire ; et
chaque passage de la pluralité de passages est caténulé.

5. Bloc de refroidissement selon la revendication 4, dans lequel :
chaque passage de la pluralité de passages comprend une pluralité de parties rétrécies et une pluralité de parties élargies ;
les parties rétrécies ont une première largeur mesurée dans la direction latérale ;
les parties élargies ont une seconde largeur mesurée dans la direction latérale, la seconde largeur étant supérieure à la première largeur ; et
les parties rétrécies et élargies sont disposées en alternance dans la direction longitudinale.

6. Bloc de refroidissement selon l'une quelconque des revendications 1 à 5, dans lequel les broches consécutives de chaque rangée de broches ont des largeurs différentes mesurées le long de la direction latérale.

7. Bloc de refroidissement selon l'une quelconque des revendications 1 à 6, dans lequel, pour chaque rangée de broches de l'au moins une rangée de broches :
chaque broche a une première extrémité pointue et une seconde extrémité pointue ;
l'axe de la broche linéaire se prolonge à travers l'une des premières extrémités pointues et la seconde extrémité pointue de chaque broche ;
les broches de la rangée de broches sont asymétriques par rapport à l'axe linéaire des broches ; et
les broches consécutives de la rangée de broches sont symétriques les unes par rapport aux autres par rapport à un plan normal à l'axe linéaire et se prolongeant entre les broches consécutives.

8. Bloc de refroidissement selon l'une quelconque des revendications 1 à 7, dans lequel :
l'au moins une rangée de broches est une rangée de broches unique ;
l'axe linéaire de la rangée de broches définissant le premier passage est parallèle à l'axe linéaire de la rangée de broches définissant le second passage ; et
les broches de la rangée de broches définissant le second passage sont décalées, dans la direction longitudinale, par rapport aux broches de la rangée de broches définissant le premier passage.

9. Bloc de refroidissement selon l'une quelconque des revendications 1 à 3, dans lequel, pour chaque passage de la pluralité de passages :
l'au moins une rangée de broches est une pluralité de rangées de broches ;
chaque paroi latérale interne des première et seconde parois latérales internes a une forme ondulée ; et
chaque paroi latérale interne des première et seconde parois latérales internes comprend une pluralité d'ondulations convexes (162) et une pluralité d'ondulations concaves (164) disposées en alternance ;
les ondulations concaves de la première paroi latérale interne sont alignées, dans la direction longitudinale, avec les ondulations convexes de la seconde paroi latérale interne ; et
les ondulations concaves de la seconde paroi latérale interne sont alignées, dans la direction longitudinale, avec les ondulations convexes de la première paroi latérale interne.

10. Bloc de refroidissement selon la revendication 9, dans lequel :
la seconde paroi latérale interne définissant le premier passage est adjacente à la première paroi latérale interne définissant le second passage ;
les ondulations concaves de la seconde paroi latérale interne définissant le premier passage sont alignées, dans la direction longitudinale, avec les ondulations convexes de la première paroi latérale interne définissant le second passage ; et
les ondulations concaves de la seconde paroi latérale interne définissant le premier passage sont partiellement alignées, dans la direction latérale, avec les ondulations concaves de la première paroi latérale interne définissant le second passage.

11. Bloc de refroidissement selon l'une quelconque des revendications 1 à 3, dans lequel, pour chaque passage de la pluralité de passages :
l'au moins une rangée de broches est une pluralité de rangées de broches ; et
pour chaque deux rangées de broches consécutives de la pluralité de rangées de broches :
l'axe linéaire traversant les broches d'une première des deux rangées de broches consécutives est parallèle à l'axe linéaire traversant les broches d'une seconde des deux rangées de broches consécutives ; et
les broches de la première des deux rangées de broches consécutives sont décalées, dans la direction longitudinale, par rapport aux broches de la seconde des deux rangées de broches consécutives.

12. Bloc de refroidissement selon la revendication 11, dans lequel :
la pluralité de rangées de broches comporte des première, deuxième et troisième rangées de broches, la deuxième rangée de broches étant disposée entre les première et troisième rangées de broches le long de la direction latérale ;
chaque passage de la pluralité de passages comprend une pluralité de parties rétrécies et une pluralité de parties élargies ;
les parties rétrécies ont une première largeur mesurée dans la direction latérale ;
les parties élargies ont une seconde largeur mesurée dans la direction latérale, la seconde largeur étant supérieure à la première largeur ;
les parties rétrécies et élargies sont disposées en alternance dans la direction longitudinale ;
les broches de la deuxième rangée de broches sont disposées dans les parties rétrécies de chaque passage de la pluralité de passages ; et
les broches des première et troisième rangées de broches sont disposées dans les parties élargies de chaque passage de la pluralité de passages.

13. Procédé de fabrication d'un bloc de refroidissement configuré pour refroidir un composant électronique générant de la chaleur, le procédé comprenant :
la fourniture d'une base pour former une partie du bloc de refroidissement ;
la formation de chaque passage d'une pluralité de passages d'un conduit de fluide du bloc de refroidissement par :
le fraisage d'un premier canal sur une surface de la base suivant un chemin défini par une première spline sinusoïdale ; et
le fraisage d'un second canal sur la surface de la base suivant un chemin défini par une seconde spline sinusoïdale,
les première et seconde splines sinusoïdales se prolongeant dans une direction longitudinale du bloc de refroidissement et étant agencées de telle sorte que le premier canal et le second canal sont interconnectés l'un à l'autre de telle sorte que, lors de l'utilisation, le fluide de refroidissement circulant dans le passage s'écoule dans le premier canal et le second canal ;
ledit fraisage des premier et second canaux formant une rangée de broches comprenant une pluralité de broches alignées de telle sorte qu'un axe de broche linéaire se prolongeant dans la direction longitudinale traverse chaque broche de la rangée de broches, les broches de la rangée de broches étant espacées les unes des autres le long de la direction longitudinale ;
chaque passage étant défini par ledit fraisage des premier et second canaux formant des première et seconde parois latérales internes (140, 142) se prolongeant dans la direction longitudinale du bloc de refroidissement de telle sorte que chaque paroi latérale interne comprend une pluralité de sections arrondies (144, 162, 164) ;
dans lequel les premier et second canaux pour chaque paire de passages consécutifs sont fraisés de sorte que :
les premières sections arrondies sur la première paroi latérale interne d'un premier passage sont décalées le long de la direction longitudinale par rapport aux deuxièmes sections arrondies sur la seconde paroi latérale interne d'un second passage, et
les troisièmes sections arrondies sur la seconde paroi latérale interne du premier passage sont décalées le long de la direction longitudinale par rapport aux quatrièmes sections arrondies sur la première paroi latérale interne du second passage.

14. Procédé selon la revendication 13, dans lequel la première spline sinusoïdale et la seconde spline sinusoïdale sont symétriques autour de l'axe de broche linéaire.

15. Procédé selon la revendication 13, dans lequel :
la première spline sinusoïdale se prolonge à partir d'une première extrémité à une seconde extrémité ;
la seconde spline sinusoïdale se prolonge à partir d'une première extrémité à une seconde extrémité ; et
la première extrémité de la première spline sinusoïdale et la première extrémité de la seconde spline sinusoïdale sont coïncidentes.
